# EUROPEAN PATENT SPECIFICATION

(11) **EP 3 855 502 B1**
(45) Date of publication and mention of the grant of the patent: **27.08.2025**
(21) Application number: 19863110.3
(22) Date of filing: 08.07.2019
(51) Int. Cl.: G06F 3/041, H10K 59/40, H10K 59/80

(54) **DISPLAY DEVICE**
ANZEIGEVORRICHTUNG
DISPOSITIF D'AFFICHAGE

(30) Priority: 21.09.2018 KR 20180114433
(43) Date of publication of application: 28.07.2021
(73) Proprietor: Samsung Display Co., Ltd., Yongin-si, Gyeonggi-Do 17113 (KR)
(72) Inventor: KIM, Byoung Yong, Seoul 08725 (KR); SONG, Seung Yong, Suwon-Si Gyeonggi-do 16687 (KR); RYU, Seung Soo, Hwaseong-Si Gyeonggi-do 18476 (KR); LEE, Dae Geun, Hwaseong-Si Gyeonggi-do 18482 (KR); LEE, Sang Duk, Yongin-Si Gyeonggi-do 17147 (KR)
(74) Representative: Dr. Weitzel & Partner
(86) International application number: PCT/KR2019/008349
(87) International publication number: WO 2020/060014

(56) References cited:
- KR-A- 20160 022 426
- US-A1- 2010 060 601
- US-A1- 2011 234 509
- US-A1- 2012 105 344
- US-A1- 2012 314 383
- US-A1- 2014 092 034
- US-A1- 2015 103 030
- US-A1- 2015 103 030

## Description

### [Technical Field]

The present invention relates to a display device.

### [Background Art]

A display device is a device for displaying a moving image or a still image, and the display device may be used as a display screen of various products such as a television, a laptop, a monitor, a billboard, an Internet of Things device, and the like as well as a portable electronic device such as a mobile phone, a smart phone, a tablet PC (personal computer), a smart watch, a watch phone, a mobile communication terminal, an electronic notebook, an e-book reader, a portable multimedia player (PMP), a navigation device, an ultra-mobile PC (UMPC), and the like.

The display device may be, for example, an organic light-emitting display device. All of image displays of display devices such as the organic light-emitting display device are due to light transmission. **In** particular, the transmittance of light may affect display quality such as brightness of the display device. Therefore, components constituting the display device may at least partially include a transparent member, for example, a glass member.

The organic light-emitting display device may include a base substrate as the glass member, a lower substrate, and an upper substrate as an encapsulation substrate. Normally, laser sealing may be used to irradiate a laser with a frit interposed between the upper and lower substrates in order to bond the glass members.

Meanwhile, a touch screen may be directly formed on the upper substrate. Normally, a display device to which this method is applied is referred to as a touch screen panel integrated display device. The touch screen may include a plurality of touch signal pads on one side, and the touch pad may be ultrasonically bonded to an external device, for example, a touch flexible printed circuit board.

However, when the laser sealing described above is performed on the lower substrate and the upper substrate on which the touch screen is formed, the laser sealing may not be smoothly performed due to a touch signal pad formed on the upper substrate.

US 2015/103030 A1 discloses an organic light emitting display device being provided with an electrostatic capacitive type touch panel function without the necessity of increasing the thickness of the display panel.

### [Disclosure]

### [Technical Problem]

An object of the present invention is directed to providing a display device in which a touch signal pad is disposed so as not to overlap a sealing region to improve bonding properties between an upper substrate and a lower substrate.

The objects of the present invention are not limited to the above-mentioned technical problems, and other technical problems not mentioned will be clearly understood by those skilled in the art from the following description.

### [Technical Solution]

One aspect of the present invention provides a display device including a display region and a non-display region surrounding the display region, the display device including: a first substrate; a second substrate facing the first substrate and including a first surface facing the first substrate and a second surface opposite to the first surface of the second substrate; a touch electrode disposed on the second surface of the second substrate and positioned in the display region; a touch signal pad terminal disposed on the second surface of the second substrate, positioned in the non-display region, and electrically connected to the touch electrode, the touch signal pad terminal comprising a first conductive layer, and a second conductive layer on and overlapping with the first conductive layer; and a sealing member interposed between the first substrate and the second substrate and coupling the first substrate and the second substrate, wherein the sealing member is positioned in the non-display region, and the touch signal pad terminal is disposed more inward than the sealing member, and the second conductive layer is made of a metal material and includes a melting region.

The touch signal pad terminal may not overlap the sealing member.

The display device may further include a display element, wherein the first substrate includes a first surface facing the second substrate and a second surface opposite to the first surface of the first substrate, and the display element may be disposed on the first surface of the first substrate.

The display element may include an anode, a cathode, and an organic emission layer disposed between the anode and the cathode.

The display element may be sealed by the first substrate, the second substrate, and the sealing member.

The second substrate may be made of glass or quartz.

The touch electrode may be disposed directly on the second surface of the second substrate.

The sealing member may include an optically transparent frit.

The touch electrode may include a transparent electrode layer containing a transparent conductive oxide.

The touch signal pad terminal may include a first conductive layer containing a transparent conductive oxide, and a second conductive layer disposed on the first conductive layer and containing an opaque metal.

The transparent electrode layer and the first conductive layer may be made of the same material.

The second conductive layer may be made of at least one of aluminum (Al), platinum (Pt), palladium (Pd), silver (Ag), magnesium (Mg), gold (Au), nickel (Ni), neodymium (Nd), iridium (Ir), chromium (Cr), calcium (Ca), titanium (Ti), tantalum (Ta), tungsten (W), copper (Cu), molybdenum (Mo), Ti/Al/Ti, Mo/Al/Mo, Mo/AlGe/Mo, Ti/Cu, and MoNb.

The display device may further include a touch printed circuit board attached onto the second surface of the second substrate.

The touch printed circuit board may include a lead terminal connected to the touch signal pad terminal.

The touch signal pad terminal and the lead terminal may be ultrasonically bonded.

The first substrate may extend from one end of the second substrate to the outside of the second substrate.

The touch printed circuit board may be bent to surround a region extending from one end of the second substrate of the first substrate, and one end of the touch printed circuit board may be positioned below the second surface of the first substrate.

Another aspect of the present invention provides a display device including a display region and a non-display region surrounding the display region, the display device including: a display substrate; an encapsulation substrate facing the display substrate and including a first surface facing the display substrate and a second surface opposite to the first surface of the encapsulation substrate; a touch electrode disposed on the second surface of the encapsulation substrate and positioned in the display region; a touch signal pad terminal disposed on the second surface of the encapsulation substrate, positioned in the non-display region, and electrically connected to the touch electrode; a display element disposed on the display region of the display substrate and sealed by the display substrate, the sealing member, and the encapsulation substrate; and a touch element disposed on the encapsulation substrate and overlapping the display region of the display substrate, wherein the touch signal pad terminal overlaps a portion of a sealing region of the display substrate, and includes a first pad conductive layer and a second pad conductive layer disposed on the first pad conductive layer and containing an opaque metal.

The touch electrode may include a transparent electrode layer containing a transparent conductive oxide.

The transparent electrode layer and the first pad conductive layer may be made of the same material.

The second pad conductive layer may be made of at least one of aluminum (Al), platinum (Pt), palladium (Pd), silver (Ag), magnesium (Mg), gold (Au), nickel (Ni), neodymium (Nd), iridium (Ir), chromium (Cr), calcium (Ca), titanium (Ti), tantalum (Ta), tungsten (W), copper (Cu), molybdenum (Mo), Ti/Al/Ti, Mo/Al/Mo, Mo/AlGe/Mo, Ti/Cu, and MoNb.

The display device may further include a display element, wherein the display substrate includes a first surface facing the encapsulation substrate and a second surface opposite to the first surface of the first substrate, and the display element may be disposed on the first surface of the display substrate.

The display element may include an anode, a cathode, and an organic emission layer disposed between the anode and the cathode.

The display element may be sealed by the display substrate, the encapsulation substrate, and the sealing member.

The encapsulation substrate may be made of glass or quartz, and the touch electrode may be disposed directly on the second surface of the encapsulation substrate.

The sealing member may include an optically transparent frit.

The display device may further include a touch printed circuit board attached onto the second surface of the encapsulation substrate, and the touch printed circuit board may include a lead terminal connected to the touch signal pad terminal.

The touch signal pad terminal and the lead terminal may be ultrasonically bonded.

The display substrate may extend from one end of the encapsulation substrate to the outside of the encapsulation substrate.

The touch printed circuit board may be bent to surround a region extending from one end of the encapsulation substrate of the display substrate, and one end of the touch printed circuit board may be positioned below the second surface of the display substrate.

Specific matters of other embodiments are included in the detailed description and the drawings.

### [Advantageous Effects]

A display device according to an exemplary embodiment of the present invention can improve bonding properties between an upper substrate and a lower substrate by disposing a touch signal pad so as not to overlap a sealing region.

Effects according to the present invention are not limited by the contents illustrated above, and more various effects are included in the present specification.

### [Description of Drawings]

FIG. 1 is a planar layout view of a display device according to an exemplary embodiment.
FIG. 2 is a cross-sectional view of the display device of FIG. 1.
FIG. 3 is a planar layout view of an upper substrate according to an exemplary embodiment.
FIG. 4 is a cross-sectional view of a touch member of a sensing region according to an exemplary embodiment.
FIG. 5 is a cross-sectional view of a touch member of a sensing region according to a modified example.
FIG. 6 is a planar layout view of a touch signal pad terminal according to an exemplary embodiment.
FIG. 7 is a cross-sectional view taken along line VII-VII'.
FIG. 8 is a cross-sectional view taken along line VIII-VIII' and line IX-IX'.
FIG. 9 is a perspective view illustrating a process of sealing an upper substrate and a lower substrate according to an exemplary embodiment.
FIG. 10 is a planar layout view of a touch signal pad terminal according to another exemplary embodiment.
FIG. 11 is a cross-sectional view taken along line XI-XI'.
FIG. 12 is a cross-sectional view taken along line XII-XII' and line XIII-XIII'.
FIG. 13 is a planar layout view of a touch signal pad terminal according to still another exemplary embodiment.
FIG. 14 is a cross-sectional view taken along line XIV-XIV'.
FIG. 15 is a cross-sectional view taken along line XV-XV' and line XVI-XVI'.
FIG. 16 is a planar layout view of an upper substrate according to yet another exemplary embodiment.
FIG. 17 is a cross-sectional view of a touch member of a sensing region according to yet another exemplary embodiment.
FIG. 18 is a planar layout view of a touch signal pad terminal according to yet another exemplary embodiment.
FIG. 19 is a cross-sectional view taken along line XIX-XIX'.
FIG. 20 is a cross-sectional view taken along line XX-XX' and line XXI-XXI'.
FIG. 21 is a cross-sectional view of a display device according to yet another exemplary embodiment.
FIG. 22 is a planar layout view of an upper substrate according to yet another exemplary embodiment.
FIG. 23 is a flowchart illustrating a method of manufacturing a display device according to yet another exemplary embodiment.
FIGS. 24 to 26 are perspective views illustrating a process of forming a touch signal pad terminal.

### [Modes of the Invention]

Advantages and features of the present invention, and methods for achieving them will be apparent with reference to the embodiments described below in detail with reference to the accompanying drawings. However, the present invention is not limited to the embodiments disclosed below but may be implemented in different forms. That is, the present invention is defined only by the scope of the claims.

When an element or layer are referred to as "on" or "on" another element or layer, this includes not only directly on another element or layer but also having another layer or element intervening therebetween. On the other hand, when an element is referred to as "directly on" or " directly above," this indicates that there is not another intervening element or layer therebetween.

The same reference numerals are used for the same or similar parts throughout the specification.

Hereinafter, exemplary embodiments of the present invention will be described with reference to the drawings.

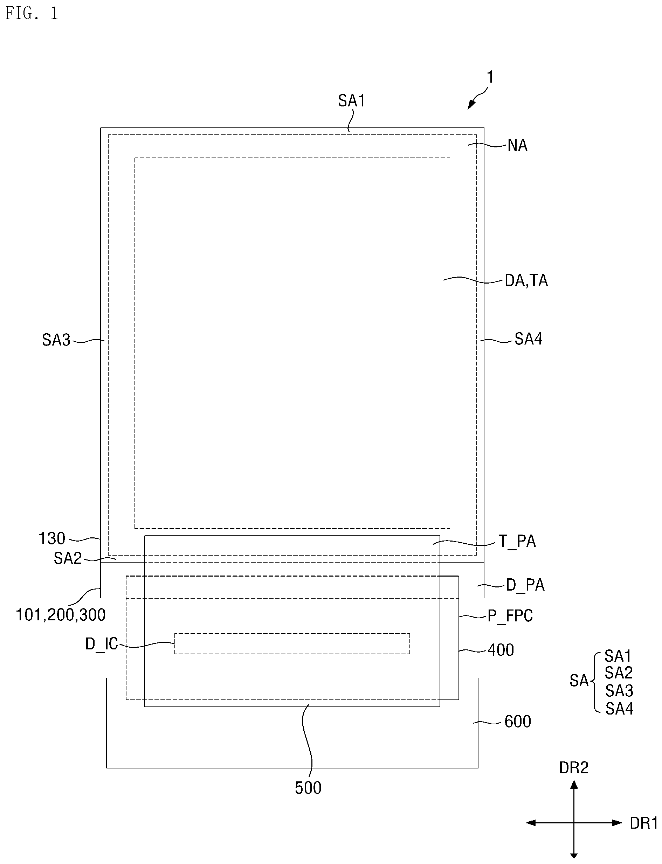

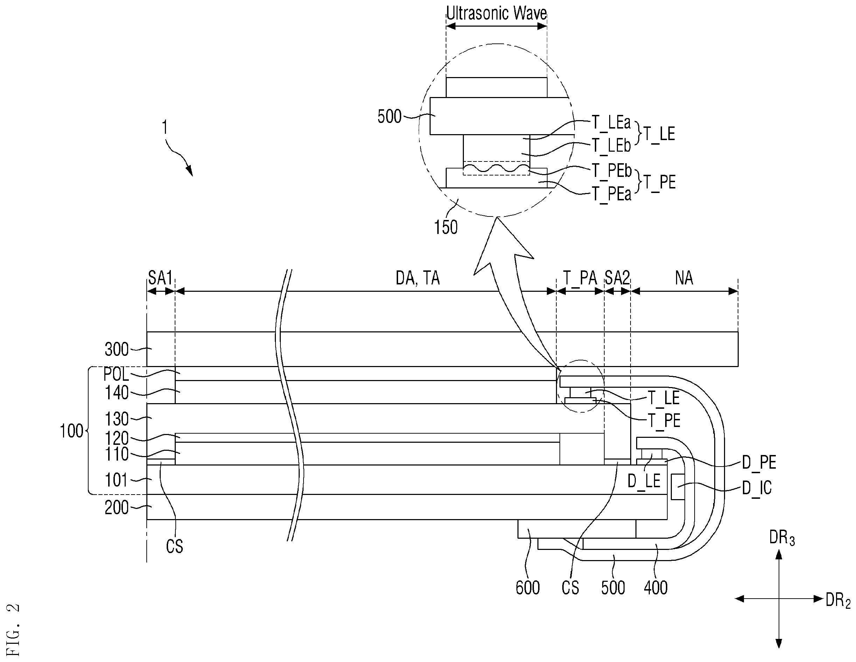

FIG. 1 is a planar layout view of a display device according to an exemplary embodiment, and FIG. 2 is a cross-sectional view of the display device of FIG. 1.

Referring to FIGS. 1 and 2, a display device 1 may include a display panel 100 displaying an image, a panel lower sheet 200 disposed below the display panel 100, a window 300 disposed on the display panel 100, a display printed circuit board 400 attached to a panel pad region P_PA of the display panel 100, and a touch printed circuit board 500 attached to a touch pad region T_PA of the display panel 100.

The display panel 100 may include a lower substrate 101, an upper substrate 130, various elements disposed on the lower substrate 101, and various elements disposed on the upper substrate 130.

The lower substrate 101 may have a rectangular shape of which a corner has a right angle on a plane. The lower substrate 101 may have a short side and a long side on the plane. The long side of the lower substrate 101 may be a side extending in a second direction DR2. The short side of the lower substrate 101 may be a side extending in a first direction DR1. The lower substrate 101 may be formed to be indent inward in one direction from one side of the upper substrate 130. For example, the lower substrate 101 may be formed to retreat inward from one end of the upper substrate 130 in the second direction DR2 from one lower end.

The upper substrate 130 may be substantially the same as the planar shape of the lower substrate 101. That is, the upper substrate 130 may be a rectangular shape of which a corner has a right angle on a plane. The upper substrate 130 may have a long side and a short side on the plane. The long side of the upper substrate 130 may be a side extending in the second direction DR2. The short side of the upper substrate 130 may be a side extending in the first direction DR1. The upper substrate 130 may be disposed to further extend in one direction from one side of the lower substrate 101. For example, one side or one end of the upper substrate 130 may protrude and extend in the second direction DR2 further than one side of the lower substrate 101. A display pad region D_PA, which will be described later, may be positioned in the extended region of the lower substrate 101.

Except for a region in which the lower substrate 101 protrudes further than the upper substrate 130, side surfaces of the lower substrate 101 and the upper substrate 130 may be aligned in a thickness direction. However, the present invention is not limited thereto, and the side surfaces of the lower substrate 101 and the upper substrate 130 may not be aligned in the thickness direction including the protruding region and may be formed so that the side surfaces of the lower substrate 101 protrude further.

A planar profile of the display panel 100 may be determined according to planar profiles of the lower substrate 101 and the upper substrate 130. In an exemplary embodiment, the display panel 100 may be the same as the planar size of the lower substrate 101 and may have a rectangular shape according to the planar shape of the lower substrate 101. The display panel 100 may be formed to include a region in which the upper substrate 130 and the lower substrate 101 overlap on the plane and a region in which the lower substrate 101 protrudes further than the upper substrate 130, that is, a region in which the lower substrate 101 further extends in the second direction DR2 than the upper substrate 130.

The lower substrate 101 may include a display region DA and a non-display region NA disposed around the display region DA. The non-display region NA of the lower substrate 101 may include a sealing region SA and a display pad region D_PA.

The display region DA may have a rectangular shape of which a corner has a right angle on a plane or a rectangular shape with rounded corners. The display region DA may have a short side and a long side. The short side of the display region DA may be a side extending in the first direction DR1. The long side of the display region DA may be a side extending in the second direction DR2. However, the planar shape of the display region DA is not limited to the rectangular shape, and may be a circular shape, an elliptical shape, or other various shapes.

The non-display region NA may be disposed around the display region DA. The non-display region NA may be disposed adjacent to both short sides and both long sides of the display region DA. In this case, the non-display region NA may surround all sides of the display region DA to form an edge of the display region DA. However, the present invention is not limited thereto, and the non-display region NA may be disposed adjacent to only both short sides or both long sides of the display region DA.

The sealing region SA may be disposed in a region in which the upper substrate 130 and the lower substrate 101 overlap in the thickness direction. The sealing region SA may be positioned along an edge portion or an edge region of the upper substrate 130. The sealing region SA may have a rectangular frame shape continuously disposed along the edge region of the upper substrate 130.

The sealing region SA may include first to fourth sealing regions SA1 to SA4. The first sealing region SA1 may be disposed adjacent to an upper short side of the display panel 100. That is, the first sealing region SA1 may be disposed adjacent to an upper short side or an upper end portion of the upper substrate 130 and the lower substrate 101.

The second sealing region SA2 may be disposed adjacent to a lower short side of the display panel 100. That is, the second sealing region SA2 may be disposed adjacent to a lower short side or a lower end portion of the upper substrate 130 and the lower substrate 101.

The third sealing region SA3 may be disposed adjacent to a left long side of the display panel 100. That is, the third sealing region SA3 may be disposed adjacent to a left long side or a left end portion of the upper substrate 130 and the lower substrate 101.

The fourth sealing region SA4 may be disposed adjacent to a right long side of the display panel 100. That is, the fourth sealing region SA4 may be disposed adjacent to right long sides of the upper substrate 130 and the lower substrate 101.

The sealing regions SA1 to SA4 may be a region in which a frit is interposed between the lower substrate 101 and the upper substrate 130 to bond the upper substrate 130 and the lower substrate 101. This will be described later.

As described above, the display pad region D_PA may be positioned on the region of the lower substrate 101 protruding further than the upper substrate 130. That is, the display pad region D_PA is a region that does not overlap the upper substrate 130 and may be disposed adjacent to the lower short side or the lower end portion of the lower substrate 101.

The upper substrate 130 may include a sensing region TA and a non-display region NA disposed around the sensing region TA.

As described later, the sensing region TA of the upper substrate 130 may be a region in which a plurality of touch electrodes 161 and 162 of the upper substrate 130 are disposed. The sensing region TA may have substantially the same shape as the display region DA on the plane. That is, the sensing region TA has a rectangular shape having long and short sides and may substantially overlap the display region DA in the thickness direction. However, the present invention is not limited thereto, and the sensing region TA may have a smaller size on a plane than the display region DA of the display panel 100, and may partially overlap the display region DA.

The non-display region NA of the upper substrate 130 may include the sealing region SA and the touch pad region T_PA.

The sealing region SA of the upper substrate 130 refers to the same region as the sealing region SA of the lower substrate 101. That is, the sealing region SA may be disposed in a region in which the upper substrate 130 and the lower substrate 101 overlap in the thickness direction. The sealing region SA may be positioned along the edge portion or the edge region of the upper substrate 130. The sealing region SA may have a rectangular frame shape continuously disposed along the edge region of the upper substrate 130.

The touch pad region T_PA may be disposed between the sensing region TA of the upper substrate 130 and the second sealing region SA2. The touch pad region T_PA may not overlap the second sealing region SA2 of the display panel 100 in the thickness direction. As described later, a plurality of touch signal pad terminals T_PE may be disposed in the touch pad region T_PA. The touch signal pad terminal T_PE may not overlap the second sealing region SA2. Accordingly, a sealing failure between the upper substrate 130 and the lower substrate 101 may be improved. This will be described later.

As the display panel 100, for example, an organic light-emitting display panel may be applied. In the following exemplary embodiment, it is illustrated that the organic light-emitting display panel is applied as the display panel 100, but the present invention is not limited thereto, and other types of display panels, such as a liquid crystal display (LCD), a quantum dot organic light-emitting display panel (QD-OLED), a quantum dot liquid crystal display (QD-LCD), a quantum nano light-emitting display panel (QNED), and a Micro LED may be applied.

As shown in FIG. 1, the display printed circuit board 400 may be disposed on the display pad region D_PA of the display panel 100. The display printed circuit board 400 may be attached to the display pad region D_PA. One end of the display printed circuit board 400 may be attached to the display pad region D_PA.

The display printed circuit board 400 may include a first base substrate 410, a plurality of display signal lead terminals D_LE, and a data driving chip D_IC.

The first base substrate 410 may be a flexible substrate. **In** an exemplary embodiment, the first base substrate 410 may be made of a flexible material such as polyimide.

The plurality of display signal lead terminals D_LE may be directly connected to display signal pad terminals D_PE of the display pad region D_PA. As described later, the display signal lead terminal D_LE may be ultrasonically bonded to the display pad terminal D_LE. The plurality of display signal lead terminals D_LE may be directly connected to the display signal pad terminals D_PE without any configuration or layer therebetween. The display signal pad terminal D_PE may be electrically connected to the display printed circuit board 400 by being connected to the display signal lead terminal D_LE. The ultrasonic bonding of the display signal pad terminal D_PE and the display signal lead terminal D_LE will be described in ultrasonic bonding between the touch signal pad terminal D_PE and the touch signal lead terminal D_LE.

The display signal lead terminal D_LE may be electrically connected to the data driving chip D_IC through a signal line. **In** the drawing, a case in which a data driving integrated circuit is applied as a driving chip and connected to the display panel 100 through a flexible printed circuit board is illustrated. However, the present invention is not limited thereto, and the data driving integrated circuit may be implemented as a driving chip and may be applied as a chip on glass (COG) mounted directly on the rigid display panel 100. In addition, when the display panel 100 is flexible, the data driving integrated circuit may be applied as a chip on plastic (COP) mounted directly on the flexible display panel 100. Hereinafter, a case in which the data driving integrated circuit is implemented as the data driving chip (D_IC) and applied as a chip on film (COF) will be mainly described.

Similarly, the touch printed circuit board 500 may be disposed on the touch pad region T_PA of the display panel 100. The touch printed circuit board 500 may be attached to the touch pad region T_PA. One end of the touch printed circuit board 500 may be attached to the touch pad region T_PA.

The touch printed circuit board 500 may partially overlap the display printed circuit board 400 in the thickness direction on one surface of the display panel 100. The touch printed circuit board 500 may overlap the display pad region D_PA and the second sealing region SA2 in the thickness direction and may be covered from above.

The touch printed circuit board 500 may include a second base substrate 510 and a plurality of touch signal lead terminals T_LE disposed on the second base substrate 510.

The second base substrate 510 may be a flexible substrate. In one exemplary embodiment, the second base substrate 510 may be made of a flexible material such as polyimide.

The plurality of touch signal lead terminals T_LE may be directly connected to the touch signal pad terminals T_PE of the touch pad region T_PA. As described later, the touch signal lead terminal T_LE may be ultrasonically bonded to the touch signal pad terminal T_LE. The plurality of touch signal lead terminals T_LE may be directly connected to the touch signal pad terminals T_PE without any configuration or layer therebetween. The touch signal pad terminal T_PE may be electrically connected to the touch printed circuit board 500 by being connected to the touch signal lead terminal T_LE. The ultrasonic bonding of the touch signal pad terminal T_PE and the touch signal lead terminal T_LE will be described later.

The other ends of the display printed circuit board 400 and the touch printed circuit board 500 may be attached to a main circuit board 600. The display printed circuit board 400 may be bent to surround one side surface outside the one side surface of the lower substrate 101 and disposed on a lower surface of the lower substrate 101. The touch printed circuit board 500 may be bent to surround one side surface of the upper substrate 101, the display printed circuit board 400, and one side surface of the lower substrate 101 and disposed on the lower surface of the lower substrate 101. The main circuit board 600 may be attached to a lower surface of the panel lower sheet 200 to be described later.

The panel lower sheet 200 may be disposed under the display panel 100. The panel lower sheet 200 may include at least one functional layer. The functional layer may be a layer that performs a heat dissipation function, an electromagnetic wave shielding function, a grounding function, a buffering function, a strength reinforcing function, a supporting function, and/or a digitizing function. The functional layer may be a sheet layer made of a sheet, a film layer made of a film, a thin film layer, a coating layer, a panel, a plate, or the like. One functional layer may be composed of a single layer, but may also be composed of a plurality of stacked thin films or coating layers. The functional layer may be, for example, a supporting substrate, a heat dissipation layer, an electromagnetic wave shielding layer, a shock absorbing layer, a digitizer, or the like. The main circuit board 600 described above may be attached to the lower surface of the panel lower sheet 200 to be described later.

The window 300 is disposed on the display panel 100. The window 300 is disposed on the display panel 100 to protect the display panel 100 while transmitting light emitted from the display panel 100. The window 300 may be made of glass or the like.

The window 300 may be disposed to overlap the display panel 100 on a plane, and to cover an entire surface of the display panel 100. The window 300 may be larger than the display panel 100. For example, on both short sides of the display device 1, the window 300 may protrude outward from the display panel 100. The window 300 may protrude from the display panel 100 even on both long sides of the display device 1, but a protruding distance may be larger in a case of both short sides. In addition, the window 300 may further extend outward from the display printed circuit board 400 and the touch printed circuit board 500 attached to the display panel 100 while being bent to cover the display printed circuit board 400 and the touch printed circuit board 500.

As described above, the display panel may include the lower substrate 101 and the upper substrate 130 and may include a circuit driving layer 110, an organic light-emitting element layer 120, a touch electrode layer 140, and a polarizing layer POL.

The lower substrate 101 and the upper substrate 130 may be rigid substrates. The upper substrate 130 may be made of a material such as glass or quartz. As shown in FIG. 2, the upper substrate 130 may mostly overlap the lower substrate 101 except for the display pad region D_PA. That is, the upper substrate 130 may be disposed from the first sealing region SA1 to the second sealing region SA2.

The upper substrate 130 may be bonded or sealed with the lower substrate 101 in the first sealing region SA1 and the second sealing region SA2. Bonding or sealing the upper substrate 130 and the lower substrate 101 may be performed through a cell seal CS. A lower surface of the upper substrate 130 and an upper surface of the lower substrate 101 in the corresponding region may be bonded or sealed to each other through the cell seal CS. Bonding of the upper substrate 130 and the lower substrate 101 may be performed by a laser sealing process. The cell seal CS may bond the upper substrate 130 and the lower substrate 101 to each other while materials such as frits are melted and solidified again.

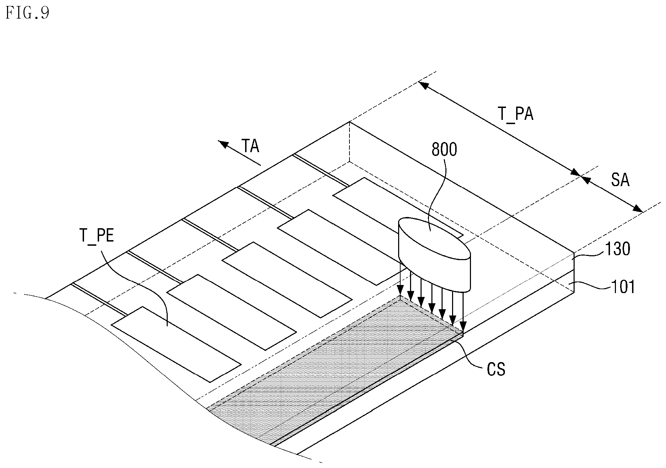

In detail, the frit may be interposed between the lower substrate 101 and the upper substrate 130 of the sealing region SA of the display panel 100. Thereafter, when laser is irradiated to the sealing region SA through a laser sealing device 800 (see FIG. 9), the frit of the corresponding region may be melted. While the molten frit is solidified, the lower substrate 101 and the upper substrate 130 may be bonded or sealed.

In the drawing, the frit is interposed between the lower substrate 101 and the upper substrate 130 to perform the sealing process, but the present invention is not limited thereto, and the lower substrate 101 and the upper substrate 130 may be directly coupled or bonded without any configuration or layer therebetween. That is, when the laser sealing device 800 irradiates a laser to the sealing region SA between the lower substrate 101 and the upper substrate 130, the lower substrate 101 and the upper substrate 130 of the corresponding region may be bonded while an interface between the lower substrate 101 and the upper substrate 130 is melted and solidified. In this case, the laser may be a femtosecond (fs) laser, but the present invention is not limited thereto.

In the display region DA and the touch pad region T_PA, the upper substrate 130 may have a shape recessed upward from the first sealing region SA1 and the second sealing region SA2. That is, the lower surface of the upper substrate 130 in the display region DA and the touch pad region T_PA may be recessed upward compared to the lower surface in the first sealing region SA1 and the second sealing region SA2. In the display region DA and the touch pad region T_PA, the upper substrate 130 and the lower substrate 101 may be spaced apart from each other. That is, the upper substrate 130 and the lower substrate 101 may have a separated space in the display region DA and the touch pad region T_PA. The circuit driving layer 110 and the organic light-emitting element layer 120 may be disposed in the separated space.

The circuit driving layer 110 may be disposed in the space in which the upper substrate 130 and the lower substrate 101 are spaced apart from each other. The circuit driving layer 110 may be disposed on one surface of the lower substrate 101. The circuit driving layer 110 may be disposed in the display region DA. The circuit driving layer 110 may include elements for providing a signal to the organic light-emitting element layer 120. The circuit driving layer 110 may include various signal lines, for example, a scan line (not shown), a data line (not shown), a power line (not shown), and a light-emitting line (not shown). The circuit driving layer 110 may include a plurality of transistors and capacitors. The transistors may include a switching transistor (not shown) and a driving transistor Qd provided for each pixel (not shown).

The organic light-emitting element layer 120 may be disposed on the circuit driving layer 110. The organic light-emitting element layer 120 may be disposed in the space in which the upper substrate 130 and the lower substrate 101 are spaced apart from each other. The organic light-emitting element layer 120 may be disposed in the display region DA. Light produced from the organic light-emitting element layer 120 may be emitted to the outside through a display surface. For example, the light produced from the organic light-emitting element layer 120 may be emitted in an upper direction, for example, a third direction DR3.

The plurality of display signal pad terminals D_PE may be disposed on the display pad region D_PA of the lower substrate 101. The plurality of display signal pad terminals D_PE may be disposed outside the second direction DR2 from the second sealing region SA2. The plurality of display signal pad terminals D_PE may not overlap the second sealing region SA2.

The touch electrode layer 140 and the polarizing layer POL may be disposed on the upper substrate 130. The touch electrode layer 140 may be disposed on the display region DA of the upper substrate 130. As described above, since the sensing region TA mostly overlaps the display region DA, it may be interpreted that the touch electrode layer 140 is disposed on the sensing region TA of the upper substrate 130. The touch electrode layer 140 may include a plurality of touch electrodes and a plurality of insulating layers. This will be described later.

The polarizing layer POL may be disposed on the touch electrode layer 140. The polarizing layer POL may be a polarizing film. The polarizing layer POL may be coupled to the touch electrode layer 140 through a bonding layer. The polarizing layer POL may be disposed in the display region DA or the sensing region TA. The polarizing layer POL may have a function of selectively transmitting and/or absorbing light coming from the outside of the display device 1 to prevent reflection of external light. In an exemplary embodiment, the polarizing layer POL may be an absorbing polarizing film. The polarizing layer POL may contain a flexible material such as polyvinyl alcohol (PVA).

However, the present invention is not limited thereto, and a polarizing film 230 may be a reflective polarizing film having a function of selectively transmitting and/or reflecting a polarization component of external light.

The touch signal pad terminal T_PE described above may be disposed in the touch pad region T_PA of the upper substrate 130. The touch signal pad terminal T_PE may be disposed in the touch pad region T_PA. The touch signal pad terminal T_PE may not overlap the second sealing region SA2 in the thickness direction. As described above, the touch printed circuit board 500 may be attached to the touch pad region T_PA. The touch signal pad terminal T_PE may be connected to the touch signal lead terminal T_LE of the touch printed circuit board 500.

In an exemplary embodiment, the touch signal pad terminal T_PE may include an opaque metal. Therefore, when the touch signal pad terminal T_PE is formed by including the opaque metal on the upper substrate 130, and then the laser sealing process of the upper substrate 130 and the lower substrate 101 is performed, the laser sealing may not be performed smoothly due to the touch signal pad terminal T_PE containing the opaque metal. For example, for the laser sealing process, the laser irradiated to the sealing region SA is partially reflected by the touch signal pad terminal T_PE including the opaque metal, and thus a sufficient amount may not be reached in the sealing region SA positioned below the touch signal pad terminal T_PE. Accordingly, a bonding failure between the upper substrate 130 and the lower substrate 101 may occur. However, as shown in an exemplary embodiment, when the touch signal pad terminal T_PE is disposed so as not to overlap the sealing region SA, the bonding failure between the upper substrate 130 and the lower substrate 101 may be improved even when the laser sealing process is performed after performing a process of disposing the touch signal pad terminal T_PE.

Hereinafter, the touch electrode layer 140 disposed on the upper substrate 130 will be described.

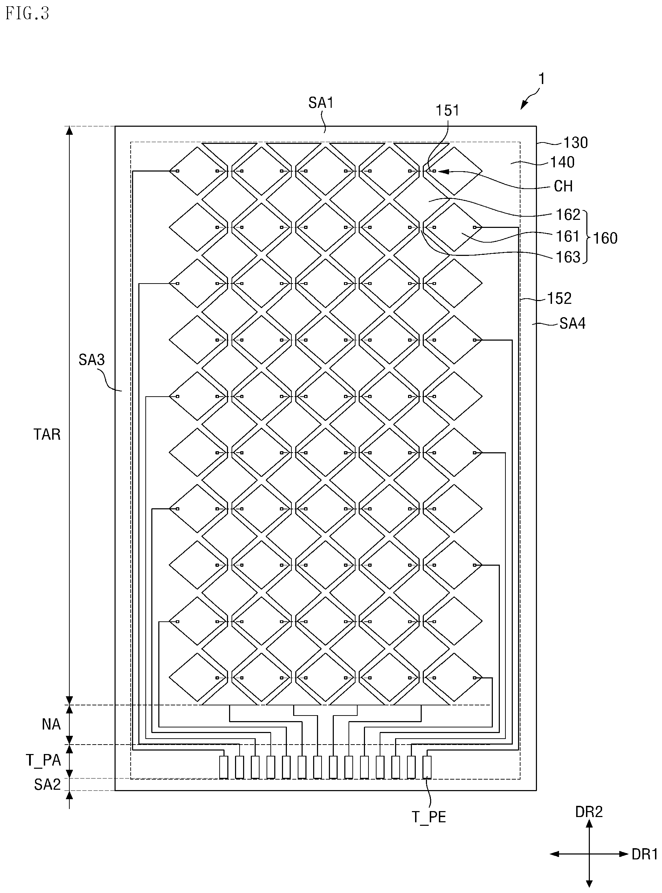

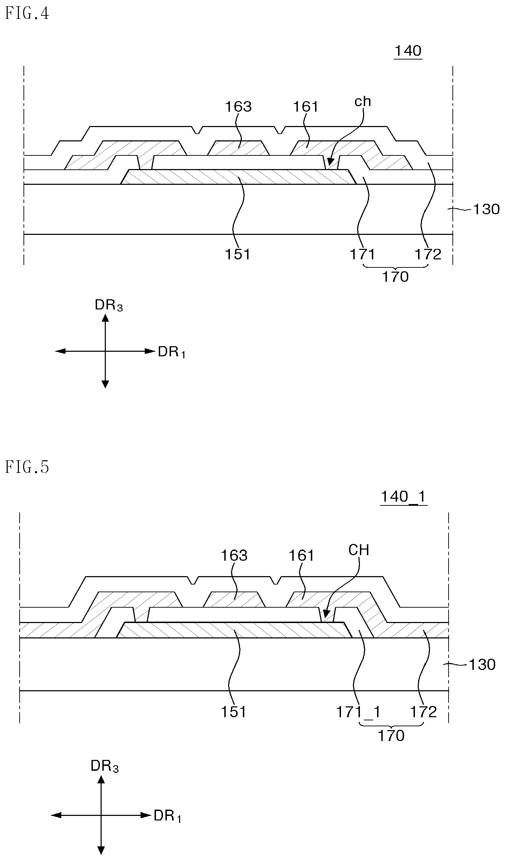

FIG. 3 is a planar layout view of an upper substrate according to an exemplary embodiment, and FIG. 4 is a cross-sectional view of a touch member of a sensing region according to an exemplary embodiment.

Referring to FIGS. 3 and 4, the upper substrate 130 includes the sensing region TA and the touch pad region T_PA described above.

The sensing region TA of the upper substrate 130 includes a first wiring layer 150, a first insulating layer 171 disposed on the first wiring layer 150, a second wiring layer 160 disposed on the first insulating layer 171, and a second insulating layer 172 disposed on the second wiring layer 160.

The first wiring layer 150 is disposed on one surface of the upper substrate 130. The first wiring layer 150 includes a first connecting wiring 151. The first connecting wiring 151 of the first wiring layer 150 is disposed on the second wiring layer 160 to be described later, and electrically connects first touch electrodes162 adjacent to each other.

The first wiring layer 150 may include a touch driving wiring 152 and a first pad electrode 153. The touch driving wiring 152 is connected to the first touch electrode 161 to extend toward the touch pad region T_PA, and forms the first pad electrode 153 in the touch pad region T_PA. The first pad electrode 153 may have a shape that is slightly more extended than the touch driving wiring 152, but the present invention is not limited thereto.

The first wiring layer 150 may be made of a conductive material. For example, the first wiring layer 150 may contain a transparent conductive oxide such as indium tin oxide (ITO), indium zinc oxide (IZO), zinc oxide (ZnO), or indium tin zinc oxide (ITZO), an opaque conductive metal such as aluminum (Al), platinum (Pt), palladium (Pd), silver (Ag), magnesium (Mg), gold (Au), nickel (Ni), neodymium (Nd), iridium (Ir), chromium (Cr), calcium (Ca), titanium (Ti), tantalum (Ta), tungsten (W), copper (Cu), molybdenum (Mo), Ti/Al/Ti, Mo/Al/Mo, Mo/AlGe/Mo, Ti/Cu, or MoNb, a conductive polymer such as PEDOT, metal nanowires, carbon nanotubes, graphene, or the like. In an exemplary embodiment, the first wiring layer 150 may contain aluminum (Al), platinum (Pt), palladium (Pd), silver (Ag), magnesium (Mg), gold (Au), nickel (Ni), neodymium (Nd), iridium (Ir), chromium (Cr), calcium (Ca), titanium (Ti), tantalum (Ta), tungsten (W), copper (Cu), molybdenum (Mo), Ti/Al/Ti, Mo/Al/Mo, Mo/AlGe/Mo, Ti/Cu, MoNb, or the like.

The first wiring layer 150 may include the touch driving wiring 152 and the first pad electrode 153. The touch driving wiring 152 is connected to the first touch electrode 161 to extend toward the touch pad region T_PA, and forms the first pad electrode 153 in the touch pad region T_PA. The first pad electrode 153 may have a shape that is slightly more extended than the touch driving wiring 152, but the present invention is not limited thereto.

The first insulating layer 171 is disposed on the first wiring layer 150. The first insulating layer 171 covers and protects the first wiring layer 150. The first insulating layer 171 may be disposed over an entire surface of the upper substrate 130. The first insulating layer 171 may include a contact hole CH exposing the first connecting wiring 151. The first touch electrode 161, which will be described later, may be electrically connected to the first connecting wiring 151 exposed through the contact hole CH. The first insulating layer 171 may include a first sub insulating layer 171a disposed in the sensing region TA and a second sub insulating layer 171b disposed in the touch pad region T_PA.

The second wiring layer 160 is disposed on one surface of the first insulating layer 171. The second wiring layer 160 includes a plurality of first touch electrodes 161, a plurality of second touch electrodes 162, and a plurality of second connecting wirings 163. The first touch electrodes 161 and the second touch electrodes 162 may acquire location information of a point touched by a self-capacitance method and/or a mutual capacitance method.

The first touch electrodes 161 and the second touch electrodes 162 may be arranged in a matrix shape. The first touch electrodes 161 and the second touch electrodes 162 may have a rhombic shape, but the present invention is not limited thereto. The first touch electrodes 161 may be electrically connected along a row direction (a short side direction), and the second touch electrodes 162 may be electrically connected along a column direction (a long side direction). However, the present invention is not limited thereto, and the first touch electrodes 161 may be electrically connected along the column direction and the second touch electrodes 162 may be electrically connected along the row direction. The first touch electrodes 161 and the second touch electrodes 162 are insulated from each other to be separated from each other.

The second wiring layer 160 includes the second connecting wiring 163 connecting the second touch electrodes 162. The second touch electrodes 162 adjacent in the column direction are physically connected through the second connecting wiring 163. A width of the second connecting wiring 163 may be smaller than that of each of the second touch electrodes 162. The second wiring layer 160 may be physically connected to the contact hole CH. When the contact hole CH is formed of a material of the second wiring layer 160, a boundary between the contact hole CH and the first touch electrode 161 is not observed. However, the contact hole CH may be formed of a material of the first wiring layer 150, or may be formed of a material different from the first wiring layer 150 and the second wiring layer 160. In this case, boundaries of the contact hole CH and the first connecting wiring 151 and the first touch electrode 161 may be observed.

The first touch electrodes 161 adjacent in the row direction in the second wiring layer 160 are physically separated. The second connecting wiring 163 of the second wiring layer 160 electrically connects the neighboring second touch electrodes 162. The width of the second connecting wiring 163 of the second wiring layer 160 may be smaller than that of each of the second touch electrodes 162.

The second wiring layer 160 may contain the exemplified material of the first wiring layer 150 described above. In an exemplary embodiment, the second wiring layer 160 may contain a transparent conductive oxide such as indium tin oxide (ITO), indium zinc oxide (IZO), zinc oxide (ZnO), or indium tin zinc oxide (ITZO).

The second insulating layer 172 is disposed on the second wiring layer 160. The second insulating layer 172 covers and protects the second wiring layer 160. The second insulating layer 172 may be disposed over an entire surface of a substrate 310.

Each of the first insulating layer 171 and the second insulating layer 172 may have a single layer structure or a multi-layer structure. In addition, each of the first insulating layer 171 and the second insulating layer 172 may contain an inorganic material, an organic material, or a composite material. In an exemplary embodiment, at least one of the first insulating layer 171 and the second insulating layer 172 may include an inorganic film. The inorganic film may contain at least one of aluminum oxide, titanium oxide, silicon oxide, silicon oxynitride, zirconium oxide, and hafnium oxide.

In another exemplary embodiment, at least one of the first insulating layer 171 and the second insulating layer 172 may include an organic film. The organic film may contain at least one of acrylic resin, methacrylic resin, polyisoprene, vinyl resin, epoxy resin, urethane resin, cellulose resin, siloxane resin, polyimide resin, polyamide resin, and perylene resin.

The first pad electrode 153 may form the touch signal pad terminal T_PE in the touch pad region T_PA. In an exemplary embodiment, the first pad electrode 153 may contain aluminum (Al), platinum (Pt), palladium (Pd), silver (Ag), magnesium (Mg), gold (Au), nickel (Ni), neodymium (Nd), iridium (Ir), chromium (Cr), calcium (Ca), titanium (Ti), tantalum (Ta), tungsten (W), copper (Cu), molybdenum (Mo), Ti/Al/Ti, Mo/Al/Mo, Mo/AlGe/Mo, Ti/Cu, or MoNb. The metals described above may be metals having a relatively low resistance as compared with materials contained in the second wiring layer 160.

FIG. 5 is a cross-sectional view of a touch member of a sensing region according to a modified example. FIG. 5 illustrates that a first insulating layer 171_1 may not extend outside the second wiring layer 160 disposed thereon, and the second wiring layer 160 may extend outside the first insulating layer 171_1.

Hereinafter, the touch signal pad terminal T_PE will be described in detail.

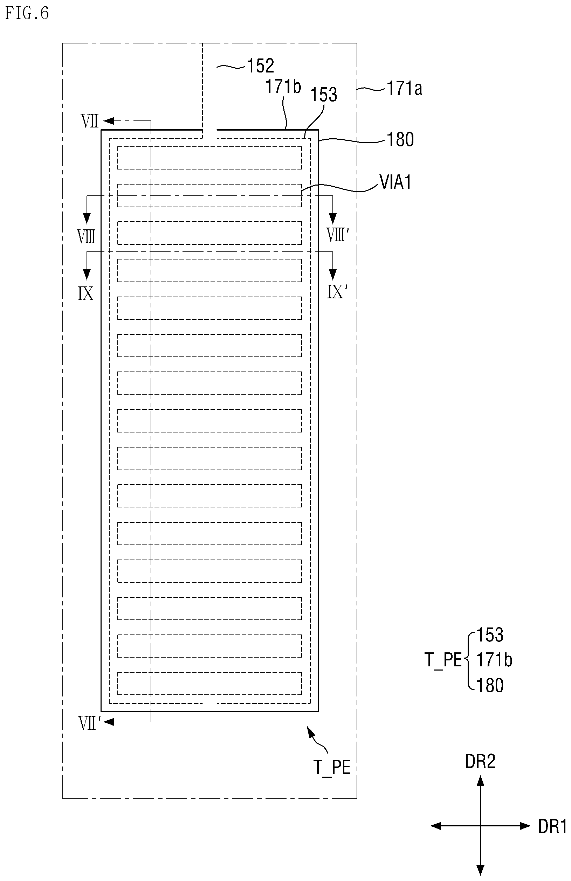

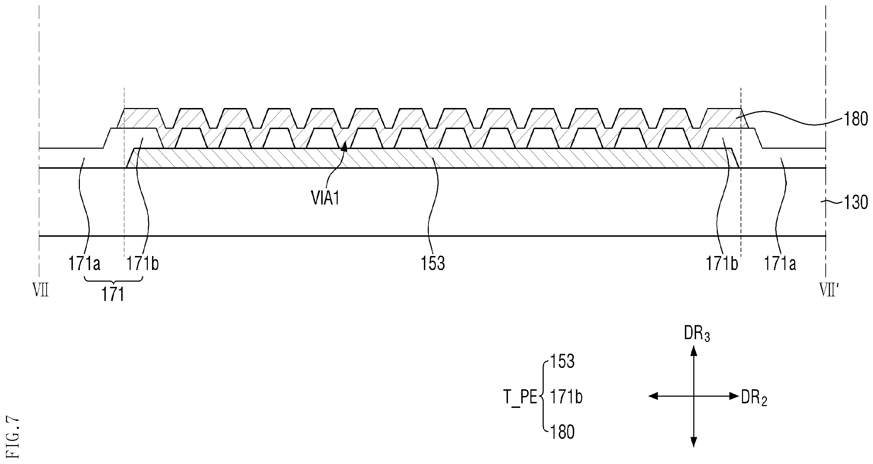

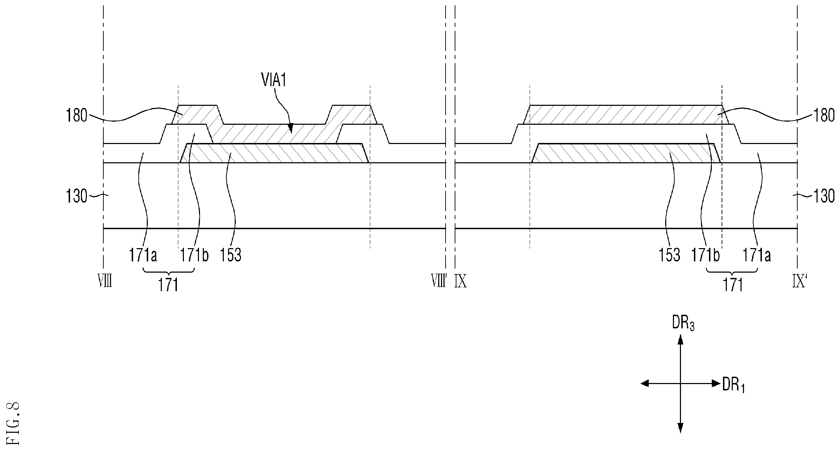

FIG. 6 is a planar layout view of a touch signal pad terminal according to an exemplary embodiment, FIG. 7 is a cross-sectional view taken along line VII-VII', and FIG. 8 is a cross-sectional view taken along line VIII-VIII' and line IX-IX'.

Referring to FIGS. 6 to 8, the touch signal pad terminal T_PE may include the first pad electrode 153, the second sub insulating layer 171b, and the second pad electrode 180. The first pad electrode 153 may be physically and electrically connected to the touch driving wiring 152. The first pad electrode 153 may have a rectangular shape having a long side edge and a short side edge. The second sub insulating layer 171b may be disposed on the first pad electrode 153 and may have the same shape as the first pad electrode 153 on a plane. A planar area of the second sub insulating layer 171b may be larger than a planar area of the first pad electrode 153. The second sub insulating layer 171b may be formed to extend outside the first pad electrode 153. The second sub insulating layer 171b may have a long side edge and a short side edge. The long side edge and the short side edge of the second sub insulating layer 171b may be extended in the second direction DR2 and the first direction DR1, respectively, like those of the first pad electrode 153. The long side edge and the short side edge of the second sub insulating layer 171b may be larger than the long side edge and the short side edge of the first pad electrode 153, respectively.

The first sub insulating layer 112a described above may be disposed outside the second sub insulating layer 171b. The first sub insulating layer 112a may surround both long and short side edges of the second sub insulating layer 171b.

The second sub insulating layer 171b may have a via hole VIA. The via hole VIA may be formed in a thickness direction on a surface of the second sub insulating layer 171b to expose an upper surface of the first pad electrode 153.

The via hole VIA may extend in the first direction DR1 and may be separated to be spaced apart in the second direction DR2. In FIG. 5, thirteen via holes VIA have been illustrated, but the number is not limited. The present invention is not limited thereto, and the via hole VIA may extend in the second direction DR2 and may be separated to be spaced apart in the first direction DR1.

The via hole VIA may have a long side and a short side on a plane. The via hole VIA may have a long side in the first direction DR1 and a short side in the second direction DR2. However, the present invention is not limited thereto, and the long side of the via hole VIA may extend in the second direction DR2, and the short side may extend in the first direction DR1. The via hole VIA may be disposed inside the first pad electrode 153 on a plane. The first pad electrode 153 may surround an insulating pattern.

The insulating pattern of the second sub insulating layer 171b may be formed between adjacent via holes VIA. The insulating pattern may be disposed on the first pad electrode 153, and further, the insulating pattern may be disposed to extend outside the first pad electrode 153. The insulating pattern may have a shape surrounding the via hole VIA on the first pad electrode 153 and may have a shape surrounding the first pad electrode 153 on a plane on the outside of the first pad electrode 153, and may form an edge of the first pad electrode 153.

The second pad electrode 180 may be disposed on the first pad electrode 153 and the second sub insulating layer 171b. The second pad electrode 180 may protrude to the outside of the first pad electrode 153 and extend. The second pad electrode 180 may cover the second sub insulating layer 171b. All side surfaces of the second pad electrode 180 may be aligned while overlapping each side surface of the second sub insulating layer 171b in the thickness direction. In addition, the first sub insulating layer 112a on a plane may be disposed outside the second pad electrode 180 to surround all sides of the second pad electrode 180 from the outside. That is, the first sub insulating layer 112a may form an edge of the second pad electrode 180. The second pad electrode 180 may cover upper and side surfaces of a plurality of insulating patterns of the second sub insulating layer 171b. The second pad electrode 180 may be disposed on the via hole VIA disposed between the insulating patterns to cover the exposed first pad electrode 153. The second pad electrode 180 may be electrically connected to the first pad electrode 153 through the via hole VIA.

The second pad electrode 180 may partially conformally reflect a lower step formed by the second sub insulating layer 171b. That is, the second pad electrode 180 has a convex portion with a surface protruding in a region in which the insulating pattern is disposed, and a concave portion with a surface indented in a region in which the insulating pattern is not disposed, that is, in a region in which the via hole VIA is formed. That is, the second sub insulating layer 171b having a predetermined step thereunder is disposed so that the second pad electrode 180 may have a concave-convex shape on the surface.

The second pad electrode 180 may be selected from the exemplified materials of the first pad electrode 153. That is, in an exemplary embodiment, the second pad electrode 180 may contain aluminum (Al), platinum (Pt), palladium (Pd), silver (Ag), magnesium (Mg), gold (Au), nickel (Ni), neodymium. (Nd), iridium (Ir), chromium (Cr), calcium (Ca), titanium (Ti), tantalum (Ta), tungsten (W), copper (Cu), molybdenum (Mo), Ti/Al/Ti, Mo/Al/Mo, Mo/AlGe/Mo, Ti/Cu, or MoNb. The materials may be ultrasonically bonded to the touch signal lead terminal T_LE disposed on the touch printed circuit board 500. This will be described in detail.

Referring again to FIG. 2, an ultrasonic apparatus 700 may vibrate the touch signal lead terminal T_LE in a vibration direction while vibrating in the predetermined vibration direction. However, in this case, the touch signal lead terminal D_LE may vibrate slightly in the vibration direction due to vibration transmitted through the touch signal lead terminal T_LE, but a vibration amplitude thereof may be insignificant. In an exemplary embodiment, the vibration direction may be the second direction DR2. That is, the vibration direction may be a direction in which long sides of the touch signal lead terminal T_LE and the touch signal pad terminal T_PE extend.

When the touch signal lead terminal T_LE is ultrasonically vibrated on one surface of the touch signal pad terminal T_PE, a predetermined frictional force is generated at an interface between one surface of the touch signal lead terminal T_LE and one surface of the touch signal pad terminal T_PE, and frictional heat may be generated by the frictional force. When the frictional heat is sufficient to melt a material forming the touch signal lead terminal T_LE and the touch signal pad terminal T _PE, a first melting region T_LEb, which is adjacent to the touch signal lead terminal T_LE, of the touch signal pad terminal T_PE and a second melting region T_PEb, which is adjacent to the touch signal lead terminal T_LE, of the touch signal pad terminal T_PE may be melted. That is, the touch signal lead terminal T_LE may include a first non-melting region T_LEa and the first melting region T_LEb. In addition, the touch signal pad terminal D_PE may include a second non-melting region T_PEa and the second melting region T_PEb.

The first non-melting region T _LEa may be a region containing only a material included in the touch signal lead terminal T_LE. The first melting region T_LEb may be a region containing a material of the touch signal lead terminal T_LE and a material contained in the touch signal pad terminal T_PE.

The second non-melting region T _LEa may be a region containing only a material contained in the touch signal pad terminal T_PE. The second melting region T_LEb may be a region containing a material of the touch signal lead terminal T_LE and a material contained in the touch signal pad terminal T_PE.

The first melting region T_LEb is a region in which the material contained in the touch signal pad terminal T_PE is diffused to mix the material of the touch signal lead terminal T_LE and the material of the touch signal pad terminal T _PE, and the second melting region T_PEb may be a region in which the material contained in the touch signal lead terminal T_LE is diffused to mix the material of the touch signal lead terminal T_LE and the material of the touch signal pad terminal T_PE. For example, when the touch signal pad terminal T_PE contains silver (Ag), gold (Au), or copper (Cu), and the touch signal lead terminal T_LE contains Ti/Al/Ti, the first melting region T_LEb and the second melting region T_PEb may be a region in which Ti and/or Al of the touch signal lead terminal T_LE and silver (Ag), gold (Au), or copper (Cu) of the touch signal pad terminal T_PE are mixed.

In the first melting region T_LEb and the second melting region T_PEb, the touch signal lead terminal T_LE and the touch signal pad terminal T_PE may be coupled while undergoing solidification.

An interface between the touch signal lead terminal T_LE and the touch signal pad terminal T _PE, that is, an interface between the first melting region T_LEb and the second melting region T_PEb may have a non-flat shape.

As described above, the touch signal pad terminal T_PE may include the second pad electrode 180. The second pad electrode 180 may be opaque.

FIG. 9 is a perspective view illustrating a process of sealing an upper substrate and a lower substrate according to an exemplary embodiment. FIG. 9 is referenced to describe an effect of a display device 1 according to an exemplary embodiment.

As described above, bonding of the upper substrate 130 and the lower substrate 101 may be performed through a laser sealing process. The cell seal CS may bond the upper substrate 130 and the lower substrate 101 to each other while a material such as a frit is melted and solidified again. The laser sealing process may be performed through the laser sealing device 900. The laser sealing device 900 may move in one direction, and may irradiate the sealing region SA of the upper substrate 130 and the lower substrate 101 to bond the upper substrate 130 and the lower substrate 101.

In addition, the second pad electrode 180 of the touch signal pad terminal T_PE described above may contain an opaque metal material such as aluminum (Al), platinum (Pt), palladium (Pd), silver (Ag), magnesium (Mg), gold (Au), nickel (Ni), neodymium (Nd), iridium (Ir), chromium (Cr), calcium (Ca), titanium (Ti), tantalum (Ta), tungsten (W), copper (Cu), molybdenum (Mo), Ti/Al/Ti, Mo/Al/Mo, Mo/AlGe/Mo, Ti/Cu, or MoNb, for ultrasonic bonding with the touch signal lead terminal T_LE.

However, when the opaque metal material is contained as the second pad electrode 180 of the touch signal pad terminal T _PE, a laser irradiated from the laser sealing device 900 to the sealing region SA, for example, the second sealing region SA2, does not pass through the touch signal pad terminal T_PE, and is partially reflected or absorbed by the second pad electrode 180 on the upper surface, and thus only a small portion of the laser may reach the sealing region SA.

In this case, the frit interposed in the sealing region SA of the upper substrate 130 and the lower substrate 101 is not melted enough to couple the upper substrate 130 and the lower substrate 101, and accordingly, bonding properties of the upper substrate 130 and the lower substrate 101 may be significantly lowered.

However, in the display device 1 according to an exemplary embodiment, the touch pad region T_PA may not overlap the sealing region SA of the display panel 100 in the thickness direction. That is, a plurality of touch signal pad terminals T_PE may not overlap the sealing region SA. Accordingly, the laser irradiated to the sealing region SA may directly pass through the upper substrate 130 without being partially reflected or absorbed by the touch signal pad terminal T_PE. As a result, it is possible to sufficiently melt the frit disposed in the sealing region SA. Therefore, even though intensity or irradiation time of the laser, which is sealing light, is not increased, it is possible to sufficiently bond the upper substrate 130 and the lower substrate 101.

Hereinafter, another example will be described. The same configuration as the embodiment described already in the following exemplary embodiment is referred to by the same reference numerals, and the description is omitted or simplified.

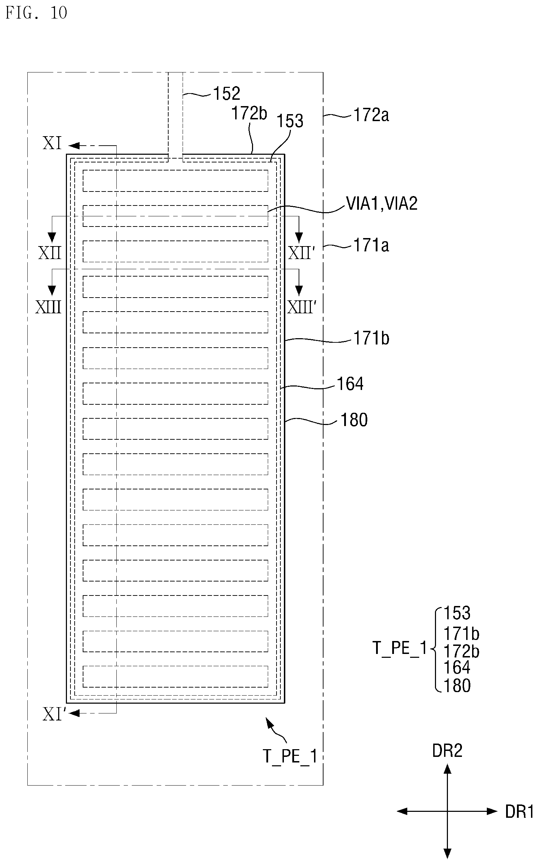

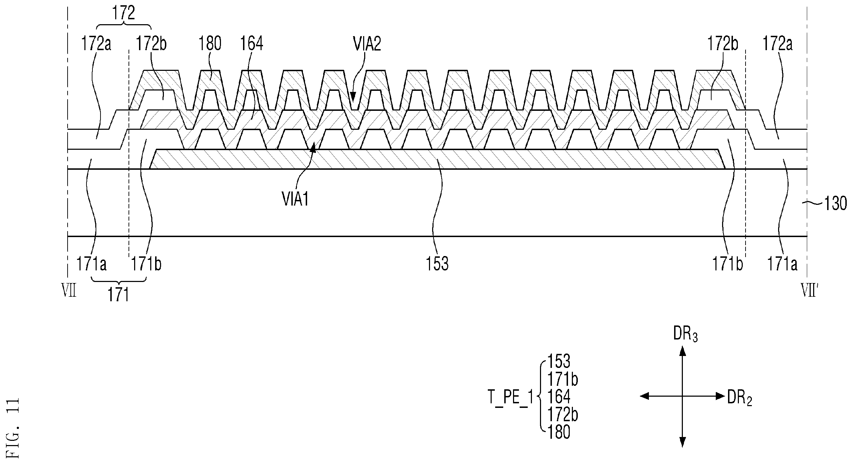

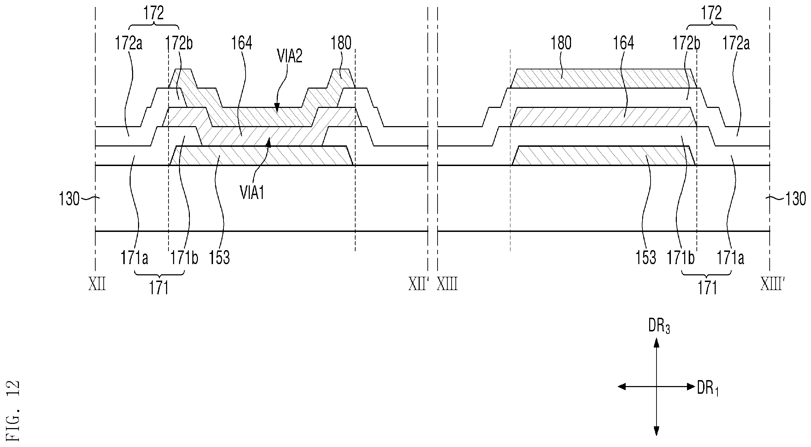

FIG. 10 is a planar layout view of a touch signal pad terminal according to another exemplary embodiment, FIG. 11 is a cross-sectional view taken along line XI-XI', and FIG. 12 is a cross-sectional view taken along line XII-XII' and line XIII-XIII' .

Referring to FIGS. 10 to 12, a touch signal pad terminal T_PE_1 according to the exemplary embodiment is different from the touch signal pad terminal T_PE according to FIGS. 6 to 8 in that a third pad electrode 164 and a fourth sub insulating layer 172b are further included.

In more detail, the touch signal pad terminal T_PE_1 may include the first pad electrode 153, the second sub insulating layer 171b disposed on the first pad electrode 153, the third pad electrode 164 disposed on the second sub insulating layer 171b, the fourth sub insulating layer 172b disposed on the third pad electrode 164, and the second pad electrode 180 disposed on the fourth sub insulating layer 172b.

The third pad electrode 164 may be disposed on one surface of the second sub insulating layer 171b and may at least partially conformally reflect a lower step formed by a plurality of insulating patterns of the second sub insulating layer 171b. Accordingly, the third pad electrode 164 may have a surface concave-convex shape. The third pad electrode 164 may be electrically connected to the first pad electrode 153 through a first via hole VIA1 of the second sub insulating layer 171b.

The third pad electrode 164 may be disposed on the second wiring layer 160 of the sensing region TA. The third pad electrode 164 may be made of a material contained in the second wiring layer 160. For example, the third pad electrode 164 may contain a transparent conductive oxide such as indium tin oxide (ITO), indium zinc oxide (IZO), zinc oxide (ZnO), or indium tin zinc oxide (ITZO).

The third pad electrode 164 may be larger than the first pad electrode 153 on a plane and smaller than the second pad electrode 180. The third pad electrode 164 may be disposed to extend outward from at least one side surface of the first pad electrode 153. The third pad electrode 164 may extend outward from all side surfaces of the first pad electrode 153. The second pad electrode 180 may be disposed to extend outward from at least one side surface of the third pad electrode 164. The second pad electrode 180 may extend outward from all side surfaces of the third pad electrode 164.

The fourth sub insulating layer 172b may be disposed on one surface of the third pad electrode 164. The fourth sub insulating layer 172b may have a second via hole VIA2 disposed between the plurality of insulating patterns and adjacent insulating patterns. The fourth sub insulating layer 172b may be disposed on the same layer as the second insulating layer 172 of the sensing region TA. That is, the second insulating layer 172 may include a third sub insulating layer 172a and the fourth sub insulating layer 172b.

The second pad electrode 180 may be electrically connected to the third pad electrode 164 through a plurality of second via holes VIA2 of the fourth sub insulating layer 172b. The second pad electrode 180 may have a concave-convex shape on the surface by reflecting at least partially conformally a step formed by the fourth sub insulating layer 172b.

Even in the case of the exemplary embodiment, when an opaque metal material is contained as the second pad electrode 180 of the touch signal pad terminal T_PE_1, a laser irradiated from the laser sealing device 900 to the sealing region SA, for example, the second sealing region SA2, does not pass through the touch signal pad terminal T_PE_1, and is partially reflected or absorbed by the second pad electrode 180 on the upper surface, and thus only a small portion of the laser may reach the sealing region SA.

In this case, the frit interposed in the sealing region SA of the upper substrate 130 and the lower substrate 101 is not melted enough to couple the upper substrate 130 and the lower substrate 101, and accordingly, bonding properties of the upper substrate 130 and the lower substrate 101 may be significantly lowered.

However, the touch pad region T_PA according to the exemplary embodiment may not overlap the sealing region SA of the display panel 100 in the thickness direction. That is, a plurality of touch signal pad terminals T_PE_1 may not overlap the sealing region SA. Accordingly, the laser irradiated to the sealing region SA may directly pass through the upper substrate 130 without being partially reflected or absorbed by the touch signal pad terminal T_PE_1. As a result, it is possible to sufficiently melt the frit disposed in the sealing region SA. Therefore, even though intensity or irradiation time of the laser, which is sealing light, is not increased, it is possible to sufficiently bond the upper substrate 130 and the lower substrate 101.

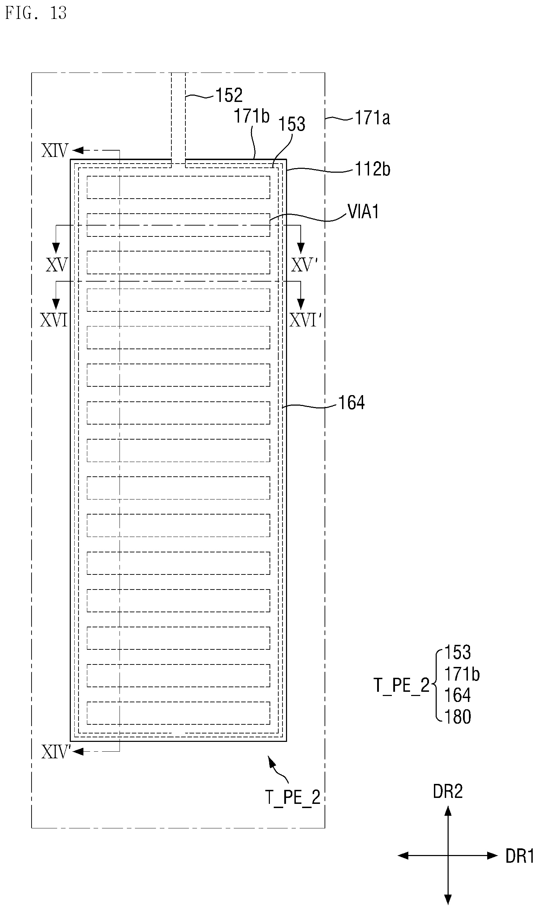

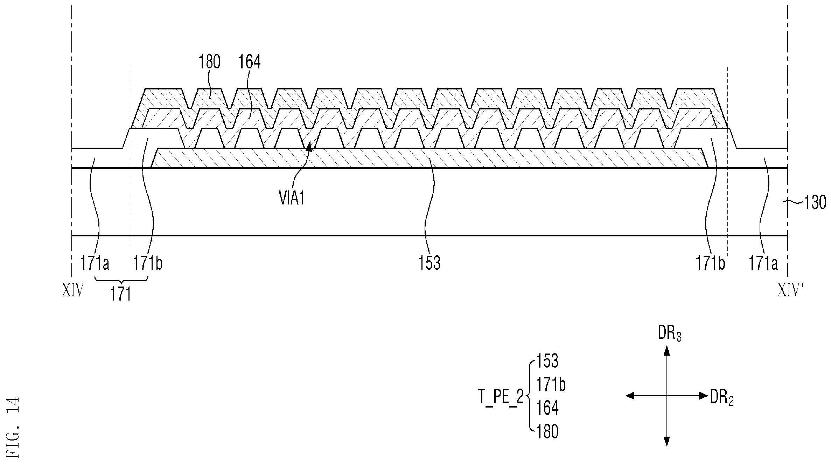

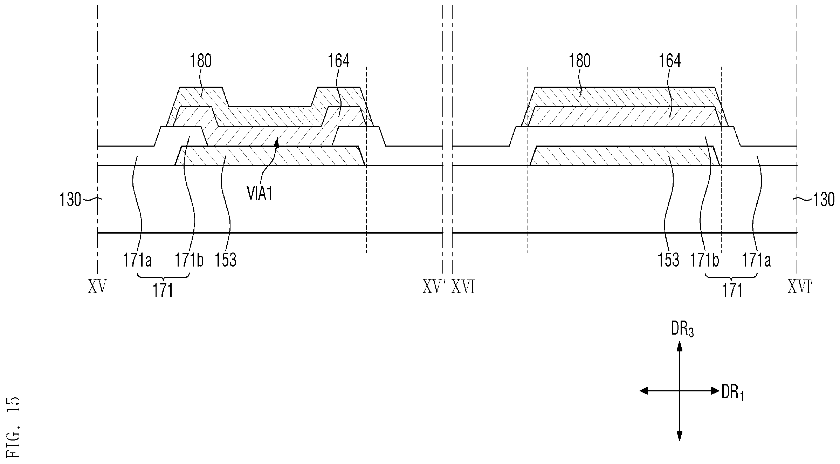

FIG. 13 is a planar layout view of a touch signal pad terminal according to still another exemplary embodiment, FIG. 14 is a cross-sectional view taken along line XIV-XIV', and FIG. 15 is a cross-sectional view taken along line XV-XV' and line XVI-XVI'.

Referring to FIGS. 13 to 15, a touch signal pad terminal T_PE_2 according to the exemplary embodiment is different from the touch signal pad terminal T_PE_1 according to FIGS. 10 to 12 in that the third pad electrode 164 is not included.

In more detail, the touch signal pad terminal T_PE_1 according to the exemplary embodiment may include the first pad electrode 153, the second sub insulating layer 171b disposed on one surface of the first pad electrode 153, the third pad electrode 164 disposed on one surface of the second sub insulating layer 171b, and the second pad electrode 180 disposed on one surface of the third pad electrode 164.

Even in the case of the exemplary embodiment, when an opaque metal material is contained as the second pad electrode 180 of the touch signal pad terminal T_PE _2, a laser irradiated from the laser sealing device 900 to the sealing region SA, for example, the second sealing region SA2, does not pass through the touch signal pad terminal T_PE_2, and is partially reflected or absorbed by the second pad electrode 180 on the upper surface, and thus only a small portion of the laser may reach the sealing region SA.

In this case, the frit interposed in the sealing region SA of the upper substrate 130 and the lower substrate 101 is not melted enough to couple the upper substrate 130 and the lower substrate 101, and accordingly, bonding properties of the upper substrate 130 and the lower substrate 101 may be significantly lowered.

However, the touch pad region T_PA according to the exemplary embodiment may not overlap the sealing region SA of the display panel 100 in the thickness direction. That is, a plurality of touch signal pad terminals T_PE_2 may not overlap the sealing region SA. Accordingly, the laser irradiated to the sealing region SA may directly pass through the upper substrate 130 without being partially reflected or absorbed by the touch signal pad terminal T_PE_2. As a result, it is possible to sufficiently melt the frit disposed in the sealing region SA. Therefore, even though intensity or irradiation time of the laser, which is sealing light, is not increased, it is possible to sufficiently bond the upper substrate 130 and the lower substrate 101.

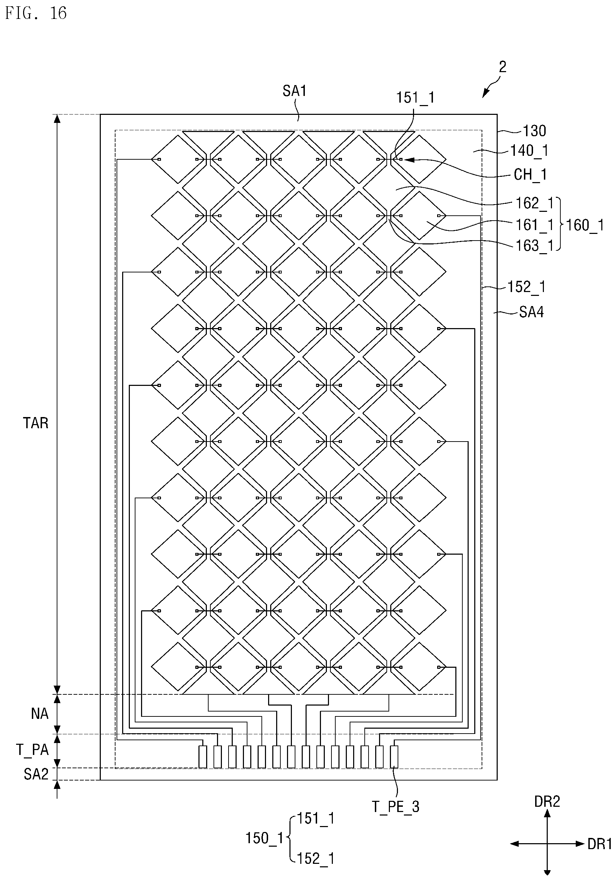

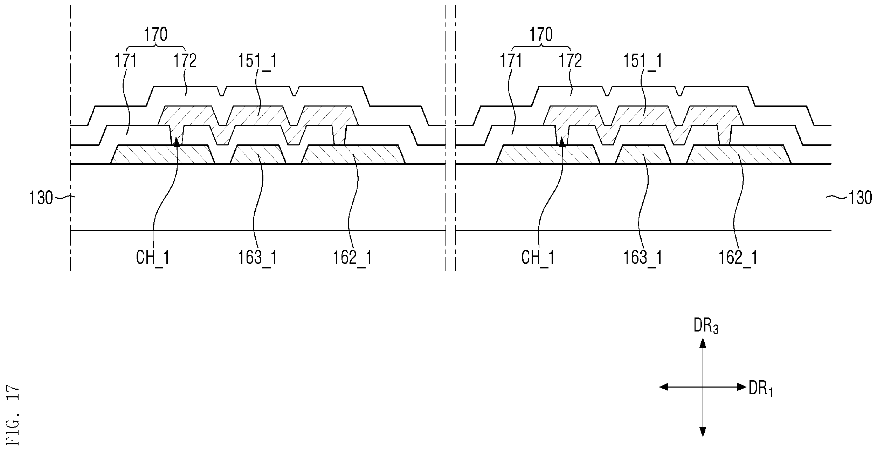

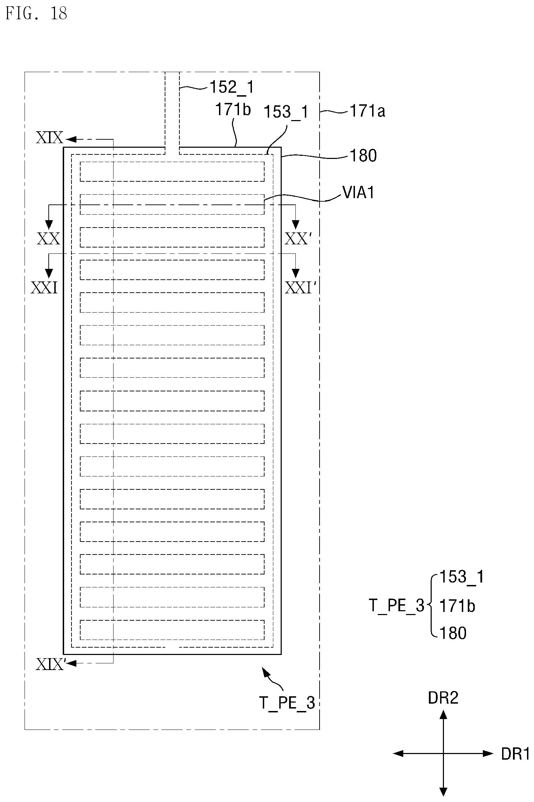

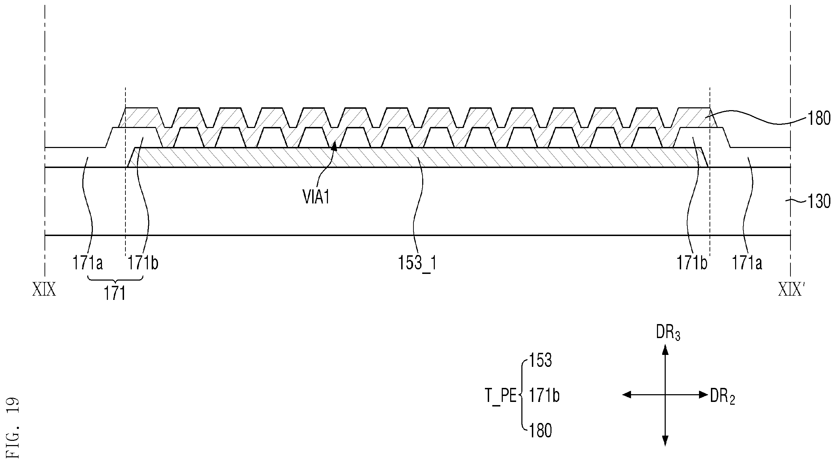

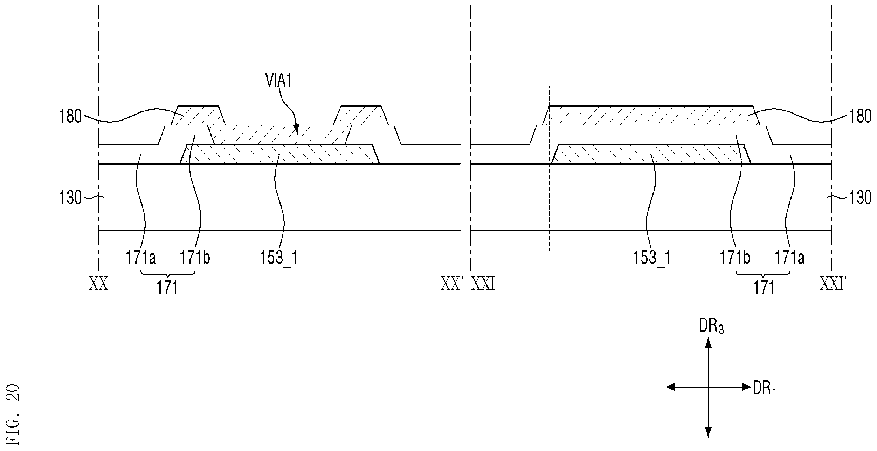

FIG. 16 is a planar layout view of an upper substrate according to yet another exemplary embodiment, FIG. 17 is a cross-sectional view of a touch member of a sensing region according to yet another exemplary embodiment, FIG. 18 is a planar layout view of a touch signal pad terminal according to yet another exemplary embodiment, FIG. 19 is a cross-sectional view taken along line XIX-XIX', and FIG. 20 is a cross-sectional view taken along line XX-XX' and line XXI-XXI'.

FIGS. 16 to 20 illustrate that the wiring layer constituting a touch element layer and a touch signal pad terminal may be variously modified.

Referring to FIGS. 16 to 20, a display device 2 according to the exemplary embodiment is different from the display device 1 according to an exemplary embodiment in that a touch element layer 140_1 and a touch signal pad terminal T_PE_3 are included.

In more detail, the touch element layer 140_1 according to the exemplary embodiment may include a first wiring layer 160_1 and a second wiring layer 150_1. The first wiring layer 160_1 includes the same configuration and material as the second wiring layer 160 of the touch element layer 140 according to an exemplary embodiment, but the arrangement is different. The second wiring layer 150_1 also includes the same configuration and material as the first wiring layer 150 of the touch element layer 140 according to an exemplary embodiment, but the arrangement is different. In detail, the first wiring layer 160_1 may include a first touch electrode 161_1, a second touch electrode 162_1, and a second connection wiring 163_1. The second wiring layer 150_1 may include a first wiring electrode 151_1, a touch driving wiring 152_1, and a first pad electrode 153_1. The first wiring layer 160_1 may be disposed on one surface of the upper substrate 130.

The first insulating layer 171 may be disposed on one surface of the first wiring layer 160_1. The second wiring layer 150_1 may be disposed on the first insulating layer 171. The first connection wiring 151_1 of the second wiring layer 150_1 may be electrically connected to the first wiring layer 160_1 through a contact hole CH_1. That is, the first connection wiring 151_1 may be electrically connected to the first touch electrode 161_1 through the contact hole CH_1.

The touch signal pad terminal T_PE_3 is different from the touch signal pad terminal T_PE according to an exemplary embodiment in that the first pad electrode 153_1 is included.

Even in the case of the exemplary embodiment, when an opaque metal material is contained as the second pad electrode 180 of the touch signal pad terminal T_PE_3, a laser irradiated from the laser sealing device 900 to the sealing region SA, for example, the second sealing region SA2, does not pass through the touch signal pad terminal T_PE_3, and is partially reflected or absorbed by the second pad electrode 180 on the upper surface, and thus only a small portion of the laser may reach the sealing region SA.

In this case, the frit interposed in the sealing region SA of the upper substrate 130 and the lower substrate 101 is not melted enough to couple the upper substrate 130 and the lower substrate 101, and accordingly, bonding properties of the upper substrate 130 and the lower substrate 101 may be significantly lowered.

However, the touch pad region T_PA according to the exemplary embodiment may not overlap the sealing region SA of the display panel 100 in the thickness direction. That is, a plurality of touch signal pad terminals T_PE_3 may not overlap the sealing region SA. Accordingly, the laser irradiated to the sealing region SA may directly pass through the upper substrate 130 without being partially reflected or absorbed by the touch signal pad terminal T_PE_3. As a result, it is possible to sufficiently melt the frit disposed in the sealing region SA. Therefore, even though intensity or irradiation time of the laser, which is sealing light, is not increased, it is possible to sufficiently bond the upper substrate 130 and the lower substrate 101.

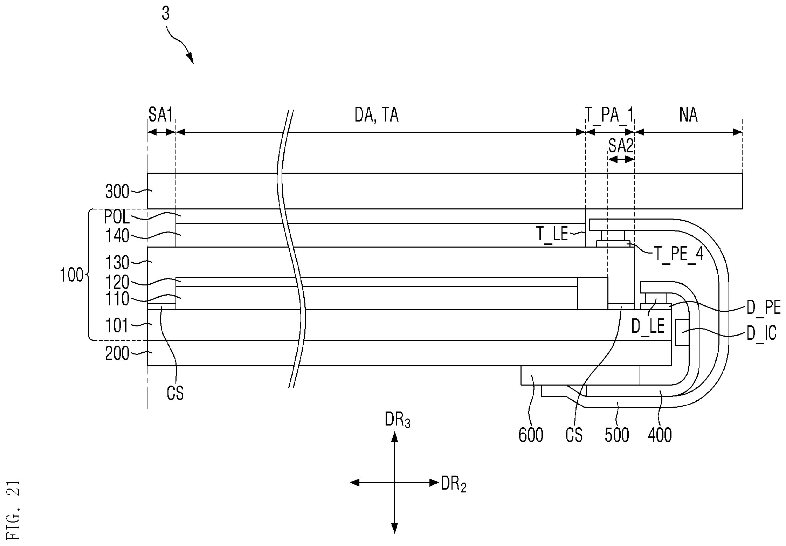

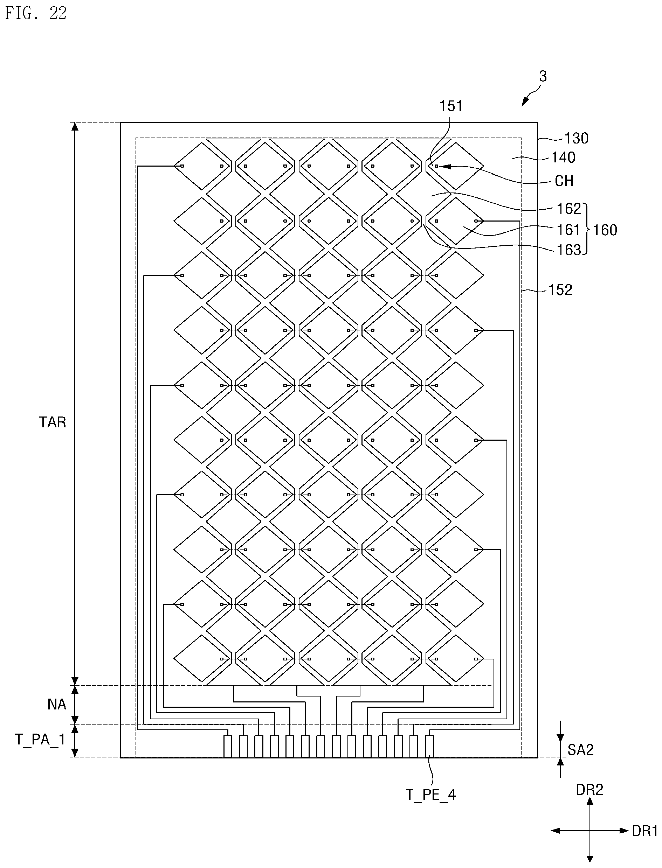

FIG. 21 is a cross-sectional view of a display device according to yet another exemplary embodiment, and FIG. 22 is a planar layout view of an upper substrate according to yet another exemplary embodiment. FIGS. 21 and 22 may be applied when a touch element layer 140 and a touch signal pad terminal T_PE_4 are formed on the upper substrate 130 after performing a sealing process of the upper substrate 130 and the lower substrate 101.

Referring to FIGS. 21 and 22 , a display device 3 according to the exemplary embodiment is different from the device 1 according to an exemplary embodiment in that a touch pad region T_PA_1 and the second sealing region SA2 partially overlap in the thickness direction.

In more detail, one side adjacent to a non-display region NA of the touch pad region T_PA_1 may be aligned with one side adjacent to a non-display region NA of the second sealing region SA2. The other side adjacent to a sensing region TA of the touch pad region T_PA_1 may be disposed to be further extended from the other side adjacent to a sensing region TA of the second sealing region SA2.

The touch signal pad terminal T_PE_4 may be disposed in the touch pad region T_PA_1. The touch signal pad terminal T_PE_4 may partially overlap the second sealing region SA2.

The touch printed circuit board 500 may be attached to the touch pad region T_PA_1. The touch signal lead terminal T_LE disposed on the touch printed circuit board 500 may be connected to the touch signal pad terminal T_PE_4. The touch printed circuit board 500 may overlap the second sealing region SA2 in the thickness direction.

As described above, the exemplary embodiment may be applied when the touch element layer 140 and the touch signal pad terminal T_PE_4 are formed after performing the sealing process of the upper substrate 130 and the lower substrate 101. The second pad electrode 180 of the touch signal pad terminal T_PE_4 may contain an opaque metal material for ultrasonic bonding with the touch signal lead terminal T_LE.

The touch element layer 140 and the touch signal pad terminal T_PE are formed on the upper substrate 130 through a process such as deposition and patterning, and, when the upper substrate 130 is bonded to the lower substrate 101 by a laser sealing process, as described above, a laser irradiated to the second sealing region SA2 does not pass through the touch signal pad terminal T_PE_3, and is partially reflected or absorbed by the opaque second pad electrode 180 on the upper surface, and thus only a small portion of the laser may reach the sealing region SA.

**In** this case, the frit interposed in the sealing region SA of the upper substrate 130 and the lower substrate 101 is not melted enough to couple the upper substrate 130 and the lower substrate 101, and accordingly, bonding properties of the upper substrate 130 and the lower substrate 101 may be significantly lowered.

However, in the display device 3 according to the exemplary embodiment, after performing the laser sealing process of the upper substrate 130 and the lower substrate 101, the touch element layer 140 and the touch signal pad terminal T_PE_4 may be formed on one surface of the upper substrate 130 through a process such as deposition and patterning. **In** this case, the touch signal pad terminal T_PE_4 may contain an opaque metal material, for example, aluminum (Al), platinum (Pt), palladium (Pd), silver (Ag), magnesium (Mg), gold (Au), nickel ( Ni), neodymium (Nd), iridium (Ir), chromium (Cr), calcium (Ca), titanium (Ti), tantalum (Ta), tungsten (W), copper (Cu), molybdenum (Mo), Ti/Al/Ti, Mo/Al/Mo, Mo/AlGe/Mo, Ti/Cu, or MoNb, and thus the touch signal pad terminal T_PE_4 may be disposed to overlap the sealing region SA because it is formed after the laser sealing process even though the laser transmittance is low.

Accordingly, the sensing region TA and the display region DA of the display device 3 may be disposed to be further extended in one direction. That is, since the touch signal pad terminal T_PE_4 may be disposed to overlap the second sealing region SA2, an area of the sensing region TA may be relatively large. In addition, the display region DA is a region in which light emitted from the organic light-emitting element layer 120 may be visually recognized from the outside, and the touch pad region T_PA_1 and the touch signal pad terminal T_PE_4 are disposed to overlap the second sealing region SA2, and thus the area may be relatively large. As a result, a viewing region of the display may be increased while reducing a bezel of the display device 3. Hereinafter, a method of manufacturing the display device 3 according to the exemplary embodiment will be described.

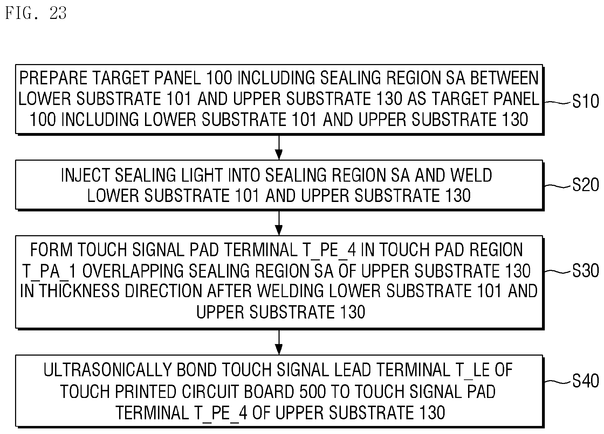

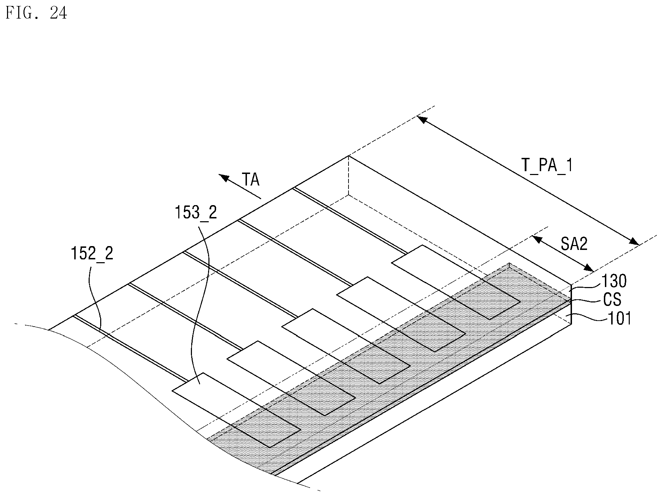

FIG. 23 is a flowchart illustrating a method of manufacturing a display device according to yet another exemplary embodiment, and FIGS. 24 to 26 are perspective views illustrating a process of forming a touch signal pad terminal.

Referring to FIGS. 23 to 26, the method of manufacturing a display device according to the exemplary embodiment may include preparing a target panel 100 including a sealing region SA between a first substrate 101 and a second substrate 150, as the target panel 100 including the first substrate 101 and the second substrate 150 (S10), injecting sealing light into the sealing region SA and welding the first substrate 101 and the second substrate 150 (S20), forming a touch signal pad terminal T_PE_4 in a touch pad region T_PA_1 overlapping the sealing region SA of the second substrate 150 in a thickness direction after welding the first substrate 101 and the second substrate 150 (S30), and ultrasonically bonding a touch signal lead terminal T_LE of a touch printed circuit board 500 to the touch signal pad terminal T_PE_4 of the second substrate 150 (S40).

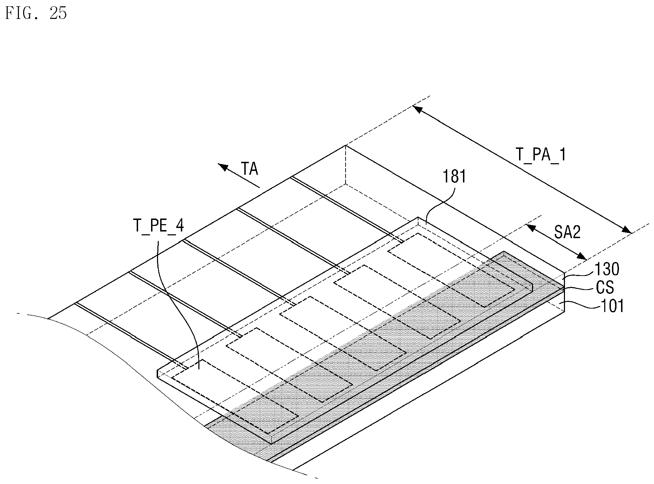

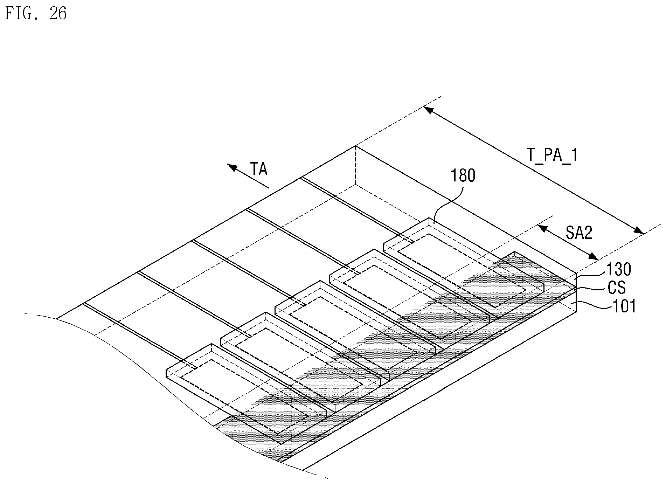

FIGS. 24 to 26 illustrate a process of forming a second pad electrode 180_1 on a first pad electrode 153_2. The second pad electrode 180_1 may be formed by a process of applying and curing a metal paste 181 on the first pad electrode 153_2 (FIG. 25) and a patterning process of the metal paste 181 (FIG. 26). Since various manufacturing methods related thereto are well known in the art, detailed descriptions thereof will be omitted.

The above description has been focused on the embodiments, but it is merely illustrative and does not limit the present invention. The scope of the present invention is defined in the appended claims.

### [Description of reference numerals]

100: Display panel
200: Panel lower sheet
300: Window
400: Display printed circuit board
500: Touch printed circuit board
600: Main circuit board
700: Ultrasonic bonding apparatus
800: Laser sealing device

## Claims

1. A display device (1, 2, 3) including a display region (DA) and a non-display region (NA) surrounding the display region (DA), the display device (1, 2, 3) comprising:
a first substrate (101);
a second substrate (130) facing the first substrate (101) and including a first surface facing the first substrate (101) and a second surface opposite to the first surface of the second substrate (130);
a touch electrode (161, 162) disposed on the second surface of the second substrate (130) and positioned in the display region (DA);
a touch signal pad terminal (T_PE) disposed on the second surface of the second substrate (130), positioned in the non-display region (NA), and electrically connected to the touch electrode (161, 162), the touch signal pad terminal (T_PE) comprising a first conductive layer containing a transparent conductive oxide, and a second conductive layer disposed on the first conductive layer; and
a sealing member (CS) interposed between the first substrate (101) and the second substrate (130) and coupling the first substrate (101) and the second substrate (130),
wherein the sealing member (CS) is positioned in the non-display region (NA), and
the touch signal pad terminal (T_PE) is disposed more inward than the sealing member (CS), and the second conductive layer is made of a metal material and includes a melting region (T_PEb).

2. The display device (1, 2) of claim 1, wherein the touch signal pad terminal (T_PE) does not overlap the sealing member (CS).

3. The display device (1, 2, 3) of claim 1, further comprising
a display element,
wherein the first substrate (101) includes a first surface facing the second substrate (130) and a second surface opposite to the first surface of the first substrate (101), and
the display element is disposed on the first surface of the first substrate (101).

4. The display device (1, 2, 3) of claim 3, wherein the display element includes an anode, a cathode, and an organic emission layer disposed between the anode and the cathode.

5. The display device (1, 2, 3) of claim 4, wherein the display element is sealed by the first substrate (101), the second substrate (130), and the sealing member (CS).

6. The display device (1, 2, 3) of claim 1, wherein the second substrate (130) is made of glass or quartz.

7. The display device (1, 2, 3) of claim 6, wherein the touch electrode (161, 162) is disposed directly on the second surface of the second substrate (130).

8. The display device (1, 2, 3) of claim 1, wherein the sealing member (CS) includes an optically transparent frit.

9. The display device (1, 2, 3) of claim 1, wherein the touch electrode (161, 162) includes a transparent electrode layer (140) containing a transparent conductive oxide.

10. The display device (1, 2, 3) of claim 9, wherein the transparent electrode layer (140) and the first conductive layer are made of the same material.

11. The display device (1, 2, 3) according to any one of claims 1 to 10, wherein the second conductive layer is made of at least one of aluminum (Al), platinum (Pt), palladium (Pd), silver (Ag), magnesium (Mg), gold (Au), nickel (Ni), neodymium (Nd), iridium (Ir), chromium (Cr), calcium (Ca), titanium (Ti), tantalum (Ta), tungsten (W), copper (Cu), molybdenum (Mo), Ti/Al/Ti, Mo/Al/Mo, Mo/AlGe/Mo, Ti/Cu, and MoNb.

12. The display device (1, 2, 3) of claim 1, further comprising a touch printed circuit board (500) attached onto the second surface of the second substrate (130).

13. The display device (1, 2, 3) of claim 12, wherein the touch printed circuit board (500) includes a lead terminal (T_LE) connected to the touch signal pad terminal (T_PE).

14. The display device (1, 2, 3) of claim 13, wherein the touch signal pad terminal (T_PE) and the lead terminal (T_LE) are ultrasonically bonded.

15. The display device (1, 2, 3) of claim 12, wherein the first substrate (101) extends from one end of the second substrate (130) to the outside of the second substrate (130).

16. The display device (1, 2, 3) of claim 15, wherein the touch printed circuit board (500) is bent to surround a region extending from one end of the second substrate (130) of the first substrate (101), and one end of the touch printed circuit board (500) is positioned below the second surface of the first substrate (101).

17. The display device (3) of one of claims 3 to 16,
wherein the touch signal pad terminal (T_PE_4) overlaps a portion of a sealing region (SA2) of the display substrate (101).

## Patentansprüche

1. Anzeigevorrichtung (1, 2, 3), beinhaltend einen Anzeigebereich (DA) und einen Nicht-Anzeigebereich (NA), der den Anzeigebereich (DA) umgibt, wobei die Anzeigevorrichtung (1, 2, 3) Folgendes umfasst:
ein erstes Substrat (101);
ein zweites Substrat (130), das dem ersten Substrat (101) zugewandt ist und eine erste Fläche, die dem ersten Substrat (101) zugewandt ist, und eine zweite Fläche, die der ersten Fläche des zweiten Substrats (130) gegenüberliegt,
beinhaltet;
eine Berührungselektrode (161, 162), die auf der zweiten Fläche des zweiten Substrats (130) angeordnet und in dem Anzeigebereich (DA) positioniert ist;
einen Berührungssignalkontaktstellenanschluss (T_PE), der auf der zweiten Fläche des zweiten Substrats (130) angeordnet, in dem Nicht-Anzeigebereich (NA) positioniert und elektrisch mit der Berührungselektrode (161, 162) verbunden ist,
wobei der Berührungssignalkontaktstellenanschluss (T_PE) eine erste leitfähige Schicht, die ein transparentes leitfähiges Oxid enthält, und eine zweite leitfähige Schicht, die auf der ersten leitfähigen Schicht angeordnet ist, umfasst; und
ein Dichtungselement (CS), das zwischen dem ersten Substrat (101) und dem zweiten Substrat (130) eingefügt ist und das erste Substrat (101) und das zweite Substrat (130) koppelt,
wobei das Dichtungselement (CS) in dem Nicht-Anzeigebereich (NA) positioniert ist und
der Berührungssignalkontaktstellenanschluss (T_PE) weiter nach innen angeordnet ist als das Dichtungselement (CS) und die zweite leitfähige Schicht aus einem Metallmaterial hergestellt ist und einen Schmelzbereich (T_PEb) beinhaltet.

2. Anzeigevorrichtung (1, 2) nach Anspruch 1, wobei der
Berührungssignalkontaktstellenanschluss (T_PE) das Dichtungselement (CS) nicht überlappt.

3. Anzeigevorrichtung (1, 2, 3) nach Anspruch 1, ferner umfassend ein Anzeigeelement,
wobei das erste Substrat (101) eine erste Fläche, die dem zweiten Substrat (130) zugewandt ist, und eine zweite Fläche, die der ersten Fläche des ersten Substrats (101) gegenüberliegt, beinhaltet und
das Anzeigeelement auf der ersten Fläche des ersten Substrats (101) angeordnet ist.

4. Anzeigevorrichtung (1, 2, 3) nach Anspruch 3, wobei das Anzeigeelement eine Anode, eine Kathode und eine organische Emissionsschicht beinhaltet, die zwischen der Anode und der Kathode angeordnet ist.

5. Anzeigevorrichtung (1, 2, 3) nach Anspruch 4, wobei das Anzeigeelement durch das erste Substrat (101), das zweite Substrat (130) und das Dichtungselement (CS) abgedichtet ist.

6. Anzeigevorrichtung (1, 2, 3) nach Anspruch 1, wobei das zweite Substrat (130) aus Glas oder Quarz hergestellt ist.

7. Anzeigevorrichtung (1, 2, 3) nach Anspruch 6, wobei die Berührungselektrode (161, 162) direkt auf der zweiten Fläche des zweiten Substrats (130) angeordnet ist.

8. Anzeigevorrichtung (1, 2, 3) nach Anspruch 1, wobei das Dichtungselement (CS) eine optisch transparente Fritte beinhaltet.

9. Anzeigevorrichtung (1, 2, 3) nach Anspruch 1, wobei die Berührungselektrode (161, 162) eine transparente Elektrodenschicht (140) beinhaltet, die ein transparentes leitfähiges Oxid enthält.

10. Anzeigevorrichtung (1, 2, 3) nach Anspruch 9, wobei die transparente Elektrodenschicht (140) und die erste leitfähige Schicht aus dem gleichen Material hergestellt sind.

11. Anzeigevorrichtung (1, 2, 3) nach einem der Ansprüche 1 bis 10, wobei die zweite leitfähige Schicht aus mindestens einem von Aluminium (AI), Platin (Pt), Palladium (Pd), Silber (Ag), Magnesium (Mg), Gold (Au), Nickel (Ni), Neodym (Nd), Iridium (Ir), Chrom (Cr), Calcium (Ca), Titan (Ti), Tantal (Ta), Wolfram (W), Kupfer (Cu), Molybdän (Mo), Ti/Al/Ti, Mo/Al/Mo, Mo/AlGe/Mo, Ti/Cu und MoNb hergestellt ist.

12. Anzeigevorrichtung (1, 2, 3) nach Anspruch 1, ferner umfassend
eine Berührungsleiterplatte (500), die an der zweiten Fläche des zweiten Substrats (130) angebracht ist.

13. Anzeigevorrichtung (1, 2, 3) nach Anspruch 12, wobei die Berührungsleiterplatte (500) einen Leitungsanschluss (T_LE) beinhaltet, der mit dem Berührungssignalkontaktstellenanschluss (T_PE) verbunden ist.

14. Anzeigevorrichtung (1, 2, 3) nach Anspruch 13, wobei der
Berührungssignalkontaktstellenanschluss (T_PE) und der Leitungsanschluss (T_LE) ultraschallverschweißt sind.

15. Anzeigevorrichtung (1, 2, 3) nach Anspruch 12, wobei sich das erste Substrat (101) von einem Ende des zweiten Substrats (130) zu der Außenseite des zweiten Substrats (130) erstreckt.

16. Anzeigevorrichtung (1, 2, 3) nach Anspruch 15, wobei die Berührungsleiterplatte (500) gebogen ist, um einen Bereich zu umgeben, der sich von einem Ende des zweiten Substrats (130) des ersten Substrats (101) erstreckt, und ein Ende der Berührungsleiterplatte (500) unter der zweiten Fläche des ersten Substrats (101) positioniert ist.

17. Anzeigevorrichtung (3) nach einem der Ansprüche 3 bis 16,
wobei der Berührungssignalkontaktstellenanschluss (T_PE_4) einen Abschnitt eines Dichtungsbereichs (SA2) des Anzeigesubstrats (101) überlappt.

## Revendications

1. Dispositif d'affichage (1, 2, 3) incluant une région d'affichage (DA) et une région de non-affichage (NA) entourant la région d'affichage (DA), le dispositif d'affichage (1, 2, 3) comprenant :
un premier substrat (101) ;
un deuxième substrat (130) faisant face au premier substrat (101) et incluant une première surface faisant face au premier substrat (101) et une deuxième surface opposée à la première surface du deuxième substrat (130) ;
une électrode tactile (161, 162) disposée sur la deuxième surface du deuxième substrat (130) et positionnée dans la région d'affichage (DA) ;
une borne de plot de signal tactile (T_PE) disposée sur la deuxième surface du deuxième substrat (130), positionnée dans la région de non-affichage (NA), et
connectée électriquement à l'électrode tactile (161, 162), la borne de plot de signal tactile (T_PE) comprenant une première couche conductrice contenant un oxyde conducteur transparent, et une deuxième couche conductrice disposée sur la première couche conductrice ; et
un organe d'étanchéité (CS) interposé entre le premier substrat (101) et le deuxième substrat (130) et couplant le premier substrat (101) et le deuxième substrat (130),
dans lequel l'organe d'étanchéité (CS) est positionné dans la région de non-affichage (NA), et
la borne de plot de signal tactile (T_PE) est disposée plus vers l'intérieur que l'organe d'étanchéité (CS), et la deuxième couche conductrice est fait d'un matériau métallique et inclut une région de fusion (T_PEb).

2. Dispositif d'affichage (1, 2) selon la revendication 1, dans lequel la borne de plot de signal tactile (T_PE) ne chevauche pas l'organe d'étanchéité (CS).

3. Dispositif d'affichage (1, 2, 3) selon la revendication 1, comprenant en outre un élément d'affichage,
dans lequel le premier substrat (101) inclut une première surface faisant face au deuxième substrat (130) et une deuxième surface opposée à la première surface du premier substrat (101), et
l'élément d'affichage est disposé sur la première surface du premier substrat (101).

4. Dispositif d'affichage (1, 2, 3) selon la revendication 3, dans lequel l'élément d'affichage inclut une anode, une cathode et une couche d'émission organique disposée entre l'anode et la cathode.

5. Dispositif d'affichage (1, 2, 3) selon la revendication 4, dans lequel l'élément d'affichage est scellé par le premier substrat (101), le deuxième substrat (130) et l'organe d'étanchéité (CS).

6. Dispositif d'affichage (1, 2, 3) selon la revendication 1, dans lequel le deuxième substrat (130) est fait de verre ou de quartz.

7. Dispositif d'affichage (1, 2, 3) selon la revendication 6, dans lequel l'électrode tactile (161, 162) est disposée directement sur la deuxième surface du deuxième substrat (130).

8. Dispositif d'affichage (1, 2, 3) selon la revendication 1, dans lequel l'organe d'étanchéité (CS) inclut une fritte optiquement transparente.

9. Dispositif d'affichage (1, 2, 3) selon la revendication 1, dans lequel l'électrode tactile (161, 162) inclut une couche d'électrode transparente (140) contenant un oxyde conducteur transparent.

10. Dispositif d'affichage (1, 2, 3) selon la revendication 9, dans lequel la couche d'électrode transparente (140) et la première couche conductrice sont faites du même matériau.

11. Dispositif d'affichage (1, 2, 3) selon l'une quelconque des revendications 1 à 10, dans lequel la deuxième couche conductrice est faite d'au moins un parmi :
l'aluminium (AI), le platine (Pt), le palladium (Pd), l'argent (Ag), le magnésium (Mg), l'or (Au), le nickel (Ni), le néodyme (Nd), l'iridium (Ir), le chrome (Cr), le calcium (Ca), le titane (Ti), le tantale (Ta), le tungstène (W), le cuivre (Cu), le molybdène (Mo), Ti/Al/Ti, Mo/Al/Mo, Mo/AlGe/Mo, Ti/Cu et MoNb.

12. Dispositif d'affichage (1, 2, 3) selon la revendication 1, comprenant en outre une carte de circuit imprimé tactile (500) fixée sur la deuxième surface du deuxième substrat (130).

13. Dispositif d'affichage (1, 2, 3) selon la revendication 12, dans lequel la carte de circuit imprimé tactile (500) inclut une borne de connexion (T_LE) connectée à la borne de plot de signal tactile (T_PE).

14. Dispositif d'affichage (1, 2, 3) selon la revendication 13, dans lequel la borne de plot de signal tactile (T_PE) et la borne de connexion (T_LE) sont liées par ultrasons.

15. Dispositif d'affichage (1, 2, 3) selon la revendication 12, dans lequel le premier substrat (101) s'étend depuis une extrémité du deuxième substrat (130) jusqu'à l'extérieur du deuxième substrat (130).

16. Dispositif d'affichage (1, 2, 3) selon la revendication 15, dans lequel la carte de circuit imprimé tactile (500) est fléchie pour entourer une région s'étendant depuis une extrémité du deuxième substrat (130) du premier substrat (101), et une extrémité de la carte de circuit imprimé tactile (500) est positionnée sous la deuxième surface du premier substrat (101).

17. Dispositif d'affichage (3) selon l'une des revendications 3 à 16,
dans lequel la borne de plot de signal tactile (T_PE_4) chevauche une portion d'une région d'étanchéité (SA2) du substrat d'affichage (101).
